(19) **Europäisches Patentamt**
**European Patent Office**
**Office européen des brevets**

(11) **EP 4 552 121 B1**

(12) **EUROPEAN PATENT SPECIFICATION**

(45) Date of publication and mention
of the grant of the patent:
**29.04.2026 Bulletin 2026/18**

(21) Application number: **23738777.4**

(22) Date of filing: **07.07.2023**

(51) International Patent Classification (IPC):
**G10L 25/48** (2013.01)     **G10L 25/18** (2013.01)
**G10L 19/032** (2013.01)

(52) Cooperative Patent Classification (CPC):
**G10L 25/48;** G10L 19/032; G10L 25/18

(86) International application number:
**PCT/EP2023/068858**

(87) International publication number:
**WO 2024/008928 (11.01.2024 Gazette 2024/02)**

(54) **MASKING THRESHOLD DETERMINATOR, METHOD AND COMPUTER PROGRAM FOR DETERMINING A MASKING THRESHOLD INFORMATION**

MASKIERUNGSSCHWELLENDETERMINATOR, VERFAHREN UND COMPUTERPROGRAMM ZUR BESTIMMUNG EINER MASKIERUNGSSCHWELLENINFORMATION

DÉTERMINATEUR DE SEUIL DE MASQUAGE, PROCÉDÉ ET PROGRAMME INFORMATIQUE POUR DÉTERMINER DES INFORMATIONS DE SEUIL DE MASQUAGE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **07.07.2022 EP 22183700**

(43) Date of publication of application:
**14.05.2025 Bulletin 2025/20**

(73) Proprietor: **Fraunhofer-Gesellschaft zur Förderung
der angewandten Forschung e.V.
80686 München (DE)**

(72) Inventors:
• **EDLER, Bernd**
**90409 Nürnberg (DE)**
• **SCHALLER, Fabian Manfred**
**90409 Nürnberg (DE)**
• **SCHÄFER, Paula**
**90409 Nürnberg (DE)**

(74) Representative: **Creutz, Andreas et al
Schoppe, Zimmermann, Stöckeler,
Zinkler, Schenk & Partner mbB
Radlkoferstraße 2
81373 München (DE)**

(56) References cited:
**WO-A1-2021/113416     WO-A2-99/62189**

• **LIN L ET AL: "Log-magnitude modelling of auditory tuning curves", 2001 IEEE INTERNATIONAL CONFERENCE ON ACOUSTICS, SPEECH, AND SIGNAL PROCESSING. PROCEEDINGS. (ICASSP). SALT LAKE CITY, UT, MAY 7 - 11, 2001; [IEEE INTERNATIONAL CONFERENCE ON ACOUSTICS, SPEECH, AND SIGNAL PROCESSING (ICASSP)], NEW YORK, NY : IEEE, US, vol. 5, 7 May 2001 (2001-05-07), pages 3293 - 3296, XP010803444, ISBN: 978-0-7803-7041-8, DOI: 10.1109/ICASSP.2001.940362**

**Description**

**Technical Field**

Embodiments according to the invention are related to masking threshold determinators, audio encoders, methods and computer programs for determining a masking threshold information.

**Background of the Invention**

The human auditory system comprises distinct characteristics for the processing of acoustic stimuli. One such characteristic is, for example, a frequency separation mechanism, performed by the inner ear (cochlea). Furthermore, human hearing is subject to masking effects, wherein a threshold of audibility for one sound is raised by the presence of another sound. In other words, in some situations, in an acoustic scene, a human is only capably of perceiving a fraction of the acoustic signals that are present in the scene. This effect can be used for determining an efficient representation and respectively transmission of an acoustic scene, for example for a reproduction of the scene.

Therefore, it is desired to get a concept for the provision of a representation of an acoustic scene, which makes a better compromise between a perceived quality and/or accuracy, a complexity and extent, for example amount of bits, of the representation of the acoustic scene and a computational complexity and an implementation complexity of the concept.

Documents WO 2021/113416 A1 (DOLBY LABORATORIES LICENSING CORP [US]) 10 June 2021 (2021-06-10) and WO 99/62189 A2 (MICROSOFT CORP [US]) 2 December 1999 (1999-12-02) are exemplary of prior art techniques for the determination of a masking threshold.

**Summary of the Invention**

Embodiments according to the invention comprise a masking threshold determinator in accordance with claim 1, wherein the masking threshold determinator is configured to obtain a plurality of bandpass signals, e.g. filterbank outputs, e.g. $x_k$, using a plurality of, for example bandpass, filters (e.g. individual filters of a filterbank; e.g. IIR filters; e.g. all-pole Gammatone filters; e.g. digital filters) having different bandwidths (e.g. having bandwidths (e.g. 3dB bandwidths) which increase monotonically (but not necessarily strictly monotonically) with increasing center frequency). Furthermore, the masking threshold determinator is configured to obtain, e.g., to determine or to derive, a masking threshold information (e.g. a masking threshold value associated with a frequency region or a frequency band or a frequency subband; e.g. $y_b$ or a value derived from $y_b$, using a linear or non-linear mapping, wherein, for example, a quantization step value may be derived from $y_b$) associated with a given frequency region, e.g. a frequency band or frequency subband, on the basis of bandpass signal values, e.g. $x_{b-1}$, $x_b$, $x_{b+1}$, of at least two bandpass signals (e.g. provided using filters having different center frequencies; e.g. of bandpass signal values of all bandpass signals).

The inventors recognized that using a plurality of filters, for example in the form of bandpass filters, a frequency separation as performed in the inner ear can be modelled efficiently. Therefore, the filters comprise different bandwidths, for example in order to represent a frequency dependent selectivity of the human inner ear. Based thereon, an acoustic signal can be processed, in order to approximate what a human would perceive. Accordingly, based on the bandpass signal values of a plurality of such bandpass signals a masking information can be obtained.

Therefore, the inventors recognized that a precise masking threshold information for a specific frequency region can be obtained based on signal values of at least two of the bandpass signals. This masking information can be further used in order to obtain a representation of an audio scene comprising the acoustic signal, so that other acoustic signals which are masked by the acoustic signal, as indicated by the masking threshold information, may not have to be taken into account, for example for an encoding, since a human may not be able to perceive said other acoustic signal.

Furthermore, using the masking threshold information, for example for a determination of scaling factors of a respective quantization, the encoding can be optimized with respect to a masking of quantization noise. As an example, for a big masked threshold, more narrowband noise can be accepted because it will be inaudible, and therefore, for example, a larger quantizer step size can be used.

According to the invention, the bandpass signal values are complex values (e.g. comprising both a real part and an imaginary part; e.g. having a complex number representation using a separate representation of a real part and of an imaginary part, or using a representation of a magnitude (absolute value) and of a phase). Furthermore, the masking threshold determinator is configured to take phases of the bandpass signal values into account when obtaining the masking threshold information (e.g. a masking threshold value associated with a frequency region or a frequency band or a frequency subband; e.g. $y_b$ or a value derived from $y_b$, using a linear or non-linear mapping, wherein, for example, a quantization step value may be derived from $y_b$) associated with the given frequency region (e.g. a frequency band or frequency subband) on the basis of bandpass signal values( e.g. $x_{b-1}$, $x_b$, $x_{b+1}$) of the at least two bandpass signals, e.g.

provided using filters having different center frequencies.

The inventors recognized that for a modelling of human acoustic perception, inter alia, IIR filters, for example with a nonlinear phase response, may be suitable, e.g. allowing a good approximation of the frequency selectivity with a limited number of parameters. As an example, All-pole gammatone filters may be used. The inventors recognized that, for example for such filters or generally speaking filters providing complex signal values, incorporation of a respective phase information may allow to improve the calculation of the masking threshold information.

According to the invention, the masking threshold determinator is configured to apply, e.g., multiply, a phase correction value (e.g., $z_{corr}$, e.g., $z_{corr,u}$, e.g., $z_{corr,l}$, e.g., a phase correction value dependent on the applied bandpass signal) to at least one, e.g., each, of the at least two bandpass signals when obtaining the masking threshold information, e.g., in order to obtain a (static) phase correction. The inventors recognized that a multiplicative phase correction may provide a good trade-off between computational effort and improvement of masking threshold determination.

According to an embodiment of the invention, the phase correction value, e.g. $z_{corr}$, describes a phase difference, e.g. $p_{src}$-$p_{dest}$, between transfer functions of, for example bandpass, filters having adjacent passbands at a transition frequency, e.g. at a crossing frequency (for example such that output signals of the filters having adjacent passbands, which are generated in response to an input signal of the masking threshold determinator having the transition frequency, are combined in a constructive manner (with a constructive interference, rather than a destructive interference)). A definition of the correction values based on a phase difference between such transfer functions may be calculated efficiently.

According to an embodiment of the invention, between a first passband, e.g., a source band, of a first, e.g. individual, filter, for example of the plurality of filters, and an adjacent second passband, e.g., a destination band, of a second, e.g. individual, filter, for example of the plurality of filters, e.g. adjacent to the first individual filter, there is a transition frequency (e.g., a crossing frequency, e.g. a transition frequency at which transfer functions of the first filter and of the second filter comprise equal magnitudes (e.g. within a tolerance of +/-30 percent)). Furthermore, a phase correction value, e.g., $z_{corr}$, e.g., $z_{corr,u}$, e.g., $z_{corr,l}$, between the first, for example individual, filter and the, for example adjacent, second, e.g. individual, filter may, for example, be (e.g. calculated using) a combination, e.g. a sum of, or a difference between, a first phase shift, e.g., $p_{src}$, between a pole, e.g., $z_{\infty,band}$, of the first passband and the crossing frequency and of a second phase shift, e.g., $p_{dest}$, between a pole, e.g., $z_{\infty,band}$, of the second passband and the crossing frequency.

The inventors recognized that a determination of the phase correction based on a transition frequency may be performed in a robust manner. In contrast to other calculation approaches, for example a determination based on centre frequency differences of the plurality of filters, situations wherein a calculation of the phase correction value is not possible, for example, because of phase differences leading to bands cancelling each other out, may be averted. The inventive approach hence allows a determination of phase correction values based on, for example, only adjacent bands of the plurality of filters. Furthermore, this way, a simple vector of phase correction values for each band may be obtained.

According to an embodiment of the invention, the first, for example individual, filter is assigned a first phase correction value, e.g., $z_{corr,l}$, relative to an adjacent filter with a smaller band index and a second phase correction value, e.g., $z_{corr,u}$, relative to an adjacent filter with a larger band index. Hence, a calculation of correction values both for upward and downward spreading, as will be discussed in detail later, may be performed. Accordingly, phase correction towards higher and lower frequency bands may be performed, allowing for a good modelling of the human auditory masking characteristics.

According to an embodiment of the invention, the masking threshold determinator is configured to a apply a non-linear mapping to respective magnitudes, e.g. by mapping $|x|$ onto $|x|^{\alpha}$, of complex values of the bandpass signal while keeping respective phase values, e.g. $\arg(x)$, of the complex values, e.g. x, unchanged except for an optional, for example static, phase correction, which may, for example, be independent from x, e.g., performing non-linear spreading.

The inventors recognized that based on a mapping to a non-linear domain, a subsequent processing of the respective magnitudes for the determination of the masking threshold information may be improved. The inventors further recognized that based on the mapped magnitudes a subsequent spreading of bandpass signals may be performed efficiently (e.g. in the non-linear domain), in order to approximate the processing of the human auditory system and to obtain the masking threshold information.

According to an embodiment of the invention, the masking threshold determinator is configured to obtain a masking threshold information associated with a given frequency region on the basis of magnitudes (e.g., and not a phase) of the bandpass signal values of the at least two bandpass signals (e.g., configured to perform magnitude spreading), e.g. while leaving phases of the bandpass signals values unconsidered.

The inventors recognized that the masking threshold information may, for example exclusively, e.g. with regard to a phase information, be determined based on the magnitudes of the bandapass signals. Hence, the determination may be performed with limited computational effort.

According to an embodiment of the invention, center frequencies of the filters of the filterbank are chosen such that there are at least three filters per Bark, and/or the filters of the filterbank comprise 3dB bandwidths which are smaller than a third of a Bark. The inventors recognized that usage of at least three filters per bark, and/or usage of filters having the above bandwidth characteristics, allows for a good trade-off between a complexity of the inventive processing, e.g. with regard to filter coefficients and computational costs and an accuracy of the determined masking threshold.

According to an embodiment of the invention, the filters of the filterbank are chosen to have an asymmetric transfer function, and/or the filterbank is an All-Pole-Gammatone filterbank, and/or the filterbank is a complex-valued All-Pole-Gammatone filterbank. The inventors recognized that one or more of the above characteristics may allow improving and/or facilitating the determination the masking information.

According to an embodiment of the invention, for the given frequency region, an attenuation of a filter of the filterbank at a frequency one Bark above and/or 1 Bark below its center frequency is at least 40 dB, or, for example, lies between 50 and 80 dB. The inventors recognized that using such an attenuation or damping may allow a good approximation of human hearing.

According to an embodiment, the masking threshold determinator is configured to perform an additional processing, e.g. for considering postmasking, in a non-linear domain. According to an embodiment, the masking threshold determinator is configured to a apply a non-linear mapping to respective magnitudes of complex values of the bandpass signal while keeping respective phase values of the complex values unchanged except for an optional phase correction; and to perform an additional processing of the non-linearly mapped magnitudes of the bandpass signal in order to consider postmasking.

Embodiments according to the invention comprise an audio encoder for encoding an input audio signal, comprising the claimed masking threshold determinator, wherein the audio encoder is configured to adjust a quantization step for quantizing the input audio signal, or a preprocessed version thereof, in dependence on the masking threshold.

Using the inventive determination of the masking information, a quantization step size may be chosen, so as to consider only, or at least substantially, the acoustically relevant portion of an audio signal that is to be encoded. Hence, an optimization of the quantization step size may not be hindered by signal portions that are not perceivable by a human because of masking.

According to an embodiment of the invention, the audio encoder is configured to determine for the given frequency region a larger value of the obtained masking threshold information, e.g., associated with the given frequency region, and a pre-determined threshold in quiet (which may, for example, be referred to as masking threshold in quiet, e.g. although not necessarily being a masking threshold in quiet, but for example only a threshold quiet. Irrespective of that, both expressions may optionally be used herein, e.g. in an interchangeable fashion), e.g., associated with the given frequency region, and to select a quantizer step size for the given frequency region based determined larger value, and, optionally, to encode an audio signal using the selected quantizer step size. In other words, the determined masking threshold may be compared to a threshold in quiet and the larger of the two may be selected in order to determine an optimized quantization step size for the encoding. Although a quality of the decoded audio signal may not necessarily be improved, based on the above features, the thresholds may be adapted in an improved manner to the human auditory system (e.g. human hearing, e.g. auditory sense). Based thereon, it may be prevented that the thresholds become unnecessarily small and a bitrate of a respective encoded audio signal may be prevented from becoming too large.

Embodiments according to the invention comprise a method for determining masking threshold information as defined in claim 14.

The method comprises obtaining a plurality of bandpass signals, e.g. filterbank outputs; e.g. $x_k$, using a plurality of filters (e.g. individual filters of a filterbank; e.g. IIR filters; e.g. all-pole Gammatone filters; e.g. digital filters) having different bandwidths (e.g. having bandwidths (e.g. 3dB band-widths) which increase monotonically (but not necessarily strictly monotonically) with in-creasing center frequency). The method further comprises obtaining, e.g., determining or deriving, the masking threshold information (e.g. a masking threshold value associated with a frequency region or a frequency band or a frequency subband; e.g. $y_b$ or a value derived from $y_b$, using a linear or non-linear mapping, wherein, for example, a quantization step value may be derived from $y_b$) associated with a given frequency region, e.g. a frequency band or frequency subband, on the basis of bandpass signal values, e.g. $x_{b-1}$, $x_b$, $x_{b+1}$, of at least two bandpass signals (e.g. provided using filters having different center frequencies; e.g. of bandpass signal values of all bandpass signals).

The method as described above is based on the same considerations as the above-described masking threshold determinator. The method can, by the way, be completed with all features and functionalities, which are also described with regard to the masking threshold determinator.

Embodiments according to the invention comprise a computer program in accordance with claim 15.

## Brief Description of the Drawings

The drawings are not necessarily to scale, emphasis instead generally being placed upon illustrating the principles of the invention. In the following description, various embodiments of the invention are described with reference to the following drawings, in which:

Fig. 1        shows a schematic view of a masking threshold determinator according to embodiments of the invention;

Fig. 2    shows a schematic view of masking threshold determinator with a phase correction determinator according to embodiments of the invention;

Fig. 3    shows a schematic view of a structure of an embodiment according to the invention;

Fig. 4    shows a schematic drawing of outer, middle, and inner ear (retrieved from [1]);

Fig. 5    shows a schematic drawing of the relation between the critical-band rate, location on the basilar membrane, and frequency of a tone (retrieved from [2]);

Fig. 6    shows a schematic plot of a level of test tone in dB over a frequency of test tone and corresponding masking thresholds;

Fig. 7    shows schematic examples of impulse response (left) and magnitude transfer function (right) of Gammatone filter (GTF) and All-pole gammatone filter (APGF) comparison (retrieved from [4]) according to embodiments;

Fig. 8    shows a schematic block diagram of an example of one filtering operation as implemented according to embodiments;

Fig. 9    shows a schematic plot of examples of frequency responses, e.g. 910 to 950, of all-pole gammatone filters according to embodiments;

Fig. 10    shows a schematic plot of an example of a first approach to estimate the phase shift between two filterbank bands src and dest using only the center frequencies, according to embodiments;

Fig. 11    shows a schematic plot of an example of a second approach to estimate the phase shift between two filterbank bands src and dest using the crossing frequency of the bands, according to embodiments

Fig. 12a,b    show in Fig. 12a a schematic block diagram of a linear spreading pipeline according to an embodiment of the invention and in Fig. 12b a schematic block diagram of an example of a nonlinear spreading pipeline according to embodiments;

Fig. 13    shows a pseudo code for linear complex spreading, according to embodiments;

Fig. 14    shows a schematic plot of an example of nonlinear superposition of two masked threshold components $L_{T,1}$ and $L_{T,2}$ resulting in the overall threshold $L_T$ (retrieved from [6]) according to embodiments;

Fig. 15    shows a schematic plot of an example of impulse response magnitudes of filterbank band 5 for nonlinear, linear, and no spreading according to embodiments of the invention;

Fig. 16    shows a schematic plot of an example of a spectrogram of the magnitude response of an APGF filterbank using an input sine signal after complex nonlinear spreading according to embodiments of the invention

Fig. 17    shows a schematic plot of an example of a spectrogram of the magnitude response of an APGF filterbank using an input 2 bark narrowband noise signal after complex nonlinear spreading according to embodiments of the invention;

Fig. 18    shows a schematic plot of an example of normalized average magnitudes using sine signal input according to embodiments of the invention;

Fig. 19    shows a schematic plot of an example of normalized average magnitudes using 2 Bark narrowband noise according to embodiments of the invention;

Fig. 20    shows a schematic plot of an example of a masked threshold estimation of the perceptual model for an input audio of an orchestra according to an embodiment of the invention;

Fig. 21        shows a schematic plot of an example of results of a WebMUSHRA listening test with 4 test items and a hidden reference, according to embodiments;

Fig. 22 to 31    show schematic spectrograms with and without spreading according to embodiments;

Fig. 32        shows a schematic view of a masking threshold determinator with a plurality of optional features, according to embodiments of the invention; and

Fig. 33        shows a schematic view of an optional configuration of the threshold analyzer of Fig. 32, according to embodiments of the invention.

## Detailed Description of the Embodiments

Equal or equivalent elements or elements with equal or equivalent functionality are denoted in the following description by equal or equivalent reference numerals even if occurring in different figures.

In the following description, a plurality of details is set forth to provide a more throughout explanation of embodiments of the present invention. However, it will be apparent to those skilled in the art that embodiments of the present invention may be practiced without these specific details. In other instances, well-known structures and devices are shown in block diagram form rather than in detail in order to avoid obscuring embodiments of the present invention. In addition, features of the different embodiments described herein after may be combined with each other, unless specifically noted otherwise.

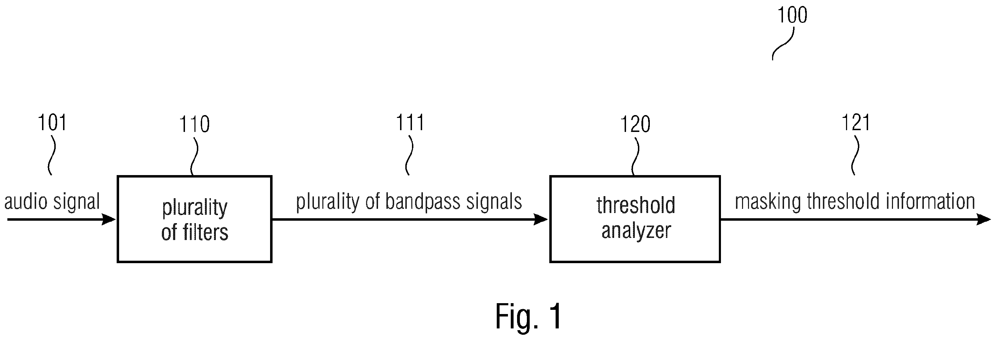

Fig. 1 shows a schematic view of a masking threshold determinator according to embodiments of the invention. Fig. 1 shows masking threshold determinator 100 comprising a plurality of filters 110 (e.g. a filterbank) and a threshold analyzer 120. Filters of the plurality of filters have different bandwidths, in order to provide a plurality of bandpass signals 111 based on an input audio signal 101. As an example, based on an appropriate choice of the filter parameters, a frequency filtering in the inner ear of a human may be approximated. Using the threshold analyzer 120, determinator 100 is configured to obtain a masking threshold information associated with a given frequency region on the basis of bandpass signal values of at least two bandpass signals.

The plurality of bandpass signals 111 comprise complex values, or in other words, bandpass signal values may be provided in the form of complex values, hence having a real part and an imaginary part, comprising a magnitude and phase information.

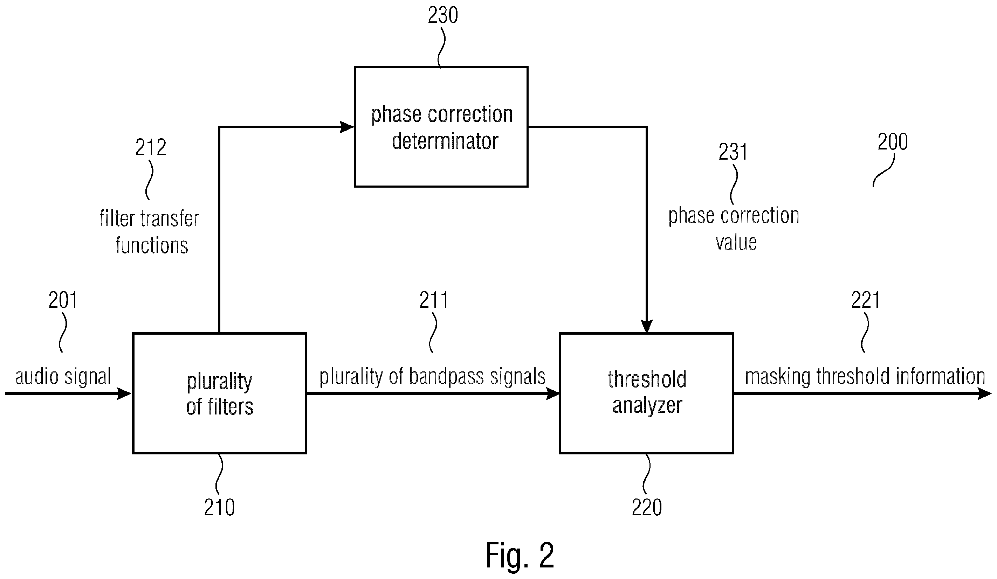

Threshold analyzer 120 is configured to analyze the phases of the at least two bandpass signals, in order to determine the masking threshold information 121 associated with the given frequency region. Therefore, threshold analyzer 120 is configured to apply a phase correction value to at least one of the at least two bandpass signals 111 when obtaining the masking threshold information 121. Optional implementations of an inventive phase correction will be further discussed in the following. It is to be noted that a corresponding phase correction determinator may be part of a respective threshold analyzer or a separate unit, as show in the following Fig. 2.

Fig. 2 shows a schematic view of masking threshold determinator with a phase correction determinator according to embodiments of the invention. Masking threshold determinator 200 comprises, corresponding to Fig. 1, a plurality of filters 210, which are provided with an audio signal 201, in order to obtain a plurality of bandpass signals 211, and a threshold analyzer 220 for providing the masking threshold information 221. The filters 210 may, optionally, have complex valued outputs 211. In particular, filters 210 may be IIR filters with a nonlinear phase response. For example, therefore, as an additional optional feature, determinator 200 comprises a phase correction determinator 230. As shown, optionally, phase correction determinator 230 may be provided with an information about filter transfer functions 212 of the plurality of filters 210. Based thereon, the phase correction determinator 230 may be configured to determine the phase correction value 231 for the threshold analyzer 220. The phase correction value 231 may describe a phase difference between transfer functions of filters having adjacent passbands at a transition frequency. Hence, phase shift deviations of different filters of the plurality of filters may be mitigated for a subsequent further processing of the bandpass signals 211.

In the following, further aspects and embodiments of the invention are discussed and other embodiments are explained in other words. In the following, contents are structured in different sections, namely, a first section "Introduction" (e.g. 1.), a second section "Methods" (e.g. 2.), comprising a first subsection "Masking" (e.g. 2.1), a second subsection "All-pole gammatone filter" (e.g. 2.2) and a third subsection "Frequency domain Spreading" (e.g. 2.3.), having a first sub-subsection "Phase correction" (e.g. 2.3.1.), a second sub-subsection "Linear spreading" (e.g. 2.3.2) and a third sub-subsection "Nonlinear spreading"(e.g. 2.3.3.), a third section "Results", comprising a first subsection "Time resolution" (e.g. 3.1), a second subsection "Magnitude response" (e.g. 3.2), a third subsection "Masked threshold estimation" (e.g. 3.3) and a fourth subsection "Listening test" (e.g. 3.4), a section "Summary of optional aspects regarding non-linear spreading (e.g. disclosing conclusions with regard to embodiments)" (e.g. 3.5), a section "Example temporal/spectral magnitude responses" (e.g. 3.6) (e.g. comprising an appendix, e.g. appendix A, e.g. showing examples of magnitude responses), and a section "Optional aspects regarding subsampling and temporal averaging" (e.g. 3.7).

Introduction

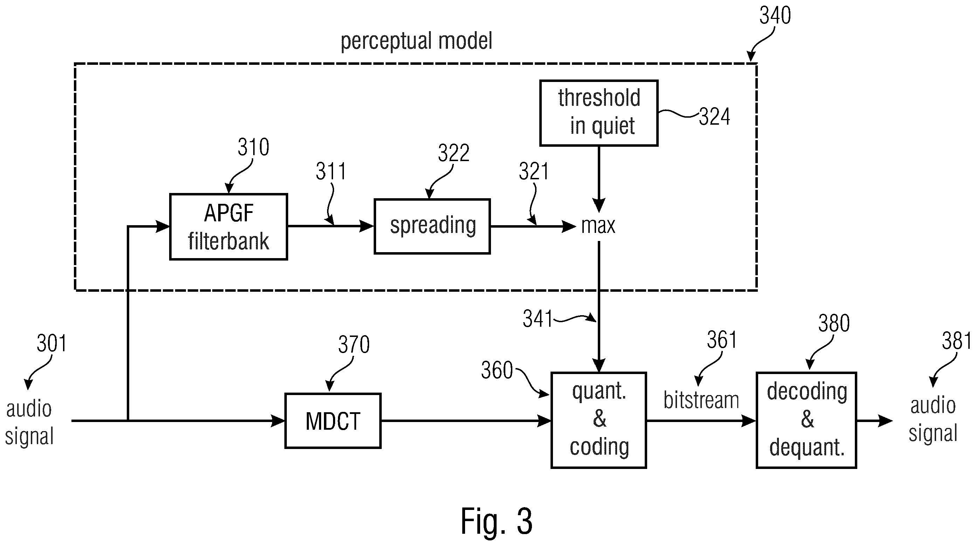

Reference is made to Fig. 3. Fig. 3 shows a schematic view of a structure of an embodiment according to the invention, e.g. a project structure. An aspect of the invention relates to a perceptual model, e.g. 340, based on a filterbank, e.g. 310, for example, an All-pole gammatone (APGT) filterbank. In the perceptual model, e.g. 340, the input audio samples, e.g. 301, may be, for example, first decomposed in their frequency components, for example, by the filterbank 310. After frequency decomposition, spreading functions, e.g. 322 may, for example, be applied to the frequency spectrum (e.g. a purality of bandpass signals 311), for example, to model the frequency separation mechanism of the human ear as closely as possible. The implemented spreading functions may, for example, be: linear magnitude spreading, linear complex spreading, nonlinear magnitude spreading and nonlinear complex spreading. The frequency spectrum resulting from the spreading functions may be used, for example, to estimate the masked threshold (also called masking threshold, e.g. 321) of the input sample. This estimated masked threshold may, for example, be compared to the threshold in quiet, e.g. 324, and the bigger value, e.g. 341, of the two thresholds may be used to optimize the quantizer step size. The idea behind this is, for example, that for a big masked threshold, more narrowband noise can be accepted because it will be inaudible, and therefore, for example, a larger quantizer step size can be used. The aim of this work was to evaluate and compare the different forms of frequency domain spreading. For example, this work relates to a psychoacoustic model with a gammatone filterbank with non-linear spreading.

Again, referring to Fig. 3, as an example, according to an embodiment, an audio signal 301 may be provided to a filterbank 310. Filterbank 310 may comprise the plurality of filters, e.g. as shown in Fig. 1 and 2. As an example, as shown in Fig. 3, the filterbank may be an APGF (All-pole gammatone filterbank). The output of the filterbank 310, e.g. a plurality of bandpass signals, is then provided to an optional spreading unit 322, which may be configured to spread the filtered spectrum. Based on the spread, filtered spectrum a masking threshold 321 may be determined which may subsequently be compared to a threshold in quiet 324, in order to provide a bigger one, e.g. 341, of the two thresholds, e.g. 321, 324, to a quantization and coding unit 360. In addition to the masking threshold information, e.g. 341, quantization and coding unit 360 is provided with a transformed version, using transformer 370, which is as an example configured to perform an MDCT (Modified Discrete Cosine Transformation), of the audio signal 301.

Hence, as discussed before, a quantization step size for the encoding of audio signal 301 may be optimized with regard to masking threshold information 341. As an example, the quantization may be optimized so that perceptually relevant acoustic information is quantized with more bits than acoustically less relevant information. Therefore, the comparison of the threshold in quiet 324 and the threshold 321, representing an approximation of the masking effects happening in a human ear for audio signal 301, may allow determining whether an acoustic information is below a general perception threshold (e.g. 324) or below a relative threshold (e.g. 321), so that such information may be neglected or only coarsely quantized for the encoding since it may not be audible anyways.

As an example, a masking threshold determinator, e.g. 100, 200, may hence comprise the filterbank 310 (e.g. representing the plurality of filters 110, 210) and a threshold analyzer, comprising the spreading unit 322 and a comparator (not shown). Inputs of the threshold analyzer may hence be a plurality of bandpass signals 311 and optionally a threshold in quiet 324, in order to output the information 341 about the masking threshold, e.g. as a result of a comparison as explained before.

In line with the above, embodiments comprise an audio encoder for encoding an input audio signal, e.g. 301, the encoder comprising a masking threshold determinator according to any of the embodiments as disclosed herein. As explained before, the audio encoder may be configured to adjust a quantization step, e.g. using a quantization and coding unit 360, for quantizing the input audio signal 301, or a preprocessed version thereof (e.g. a transformed version thereof), in dependence on the masking threshold 341.

In particular, an encoder according to embodiments may be configured to determine for the given frequency region a larger value of the obtained masking threshold information, e.g. 321, and a pre-determined threshold in quiet, e.g. 324 (e.g. referred to as masking threshold in quiet), to select, e.g. using a quantization and coding unit 360, a quantizer step size for the given frequency region based on the determined larger value, and, optionally, and to encode the audio signal,e.g. 301 using the selected quantizer step size.

Hence, the audio signal may be encoded in a bitstream 361, which may consequently be processed in a corresponding decoder, e.g. comprising a decoding and dequantization unit 380, in order to provide a decoded version of the audio signal 381.

As indicated in Fig. 3, a masking threshold determinator according to embodiments may be configured to apply a perceptual model to the audio signal 301 in order to determine a masking threshold information 341, which may allow optimizing an encoding of audio signal 301, so that a quantization step size of the encoding matches an acoustic relevance of the respective encoded portion of the audio signal 301.

Methods

Masking

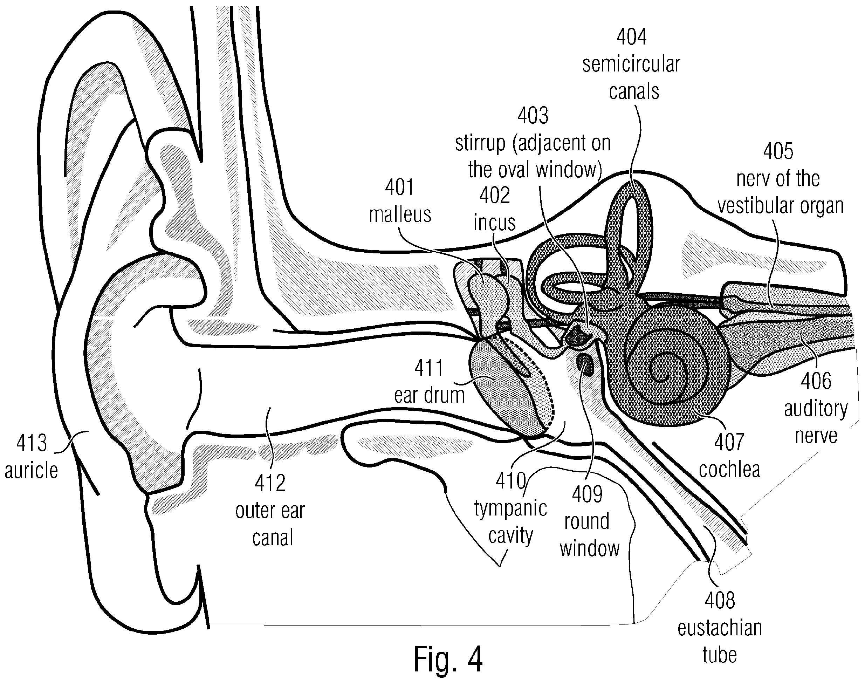

Reference is made to Fig. 4. Fig. 4 shows as schematic drawing of outer, middle, and inner ear (retrieved from [1]). Fig. 4 shows the malleus 401, the incus 402, the stirrup 403 (adjacent to the oval window), the semicircular canals 404, the nerve of the vestibular organ 405, the auditory nerve 406, the cochlea 407, the eustachian tube 408, the round window 409, the tympanic cavity 410, the ear drum 411, the outer ear canal 412 and the auricle 413.

The human ear can be separated into three main parts: the outer, middle, and inner ear (Fig. 4). The outer ear collects sound energy and transmits it through the outer ear canal to the ear drum. Because the inner ear contains fluids that surround the sensory cells, the middle ear transforms the oscillations of air particles, which are picked up by the outer ear, into oscillations in fluid. These oscillations are then lead into the inner ear (cochlea) and transmitted to the basilar membrane through the fluid.

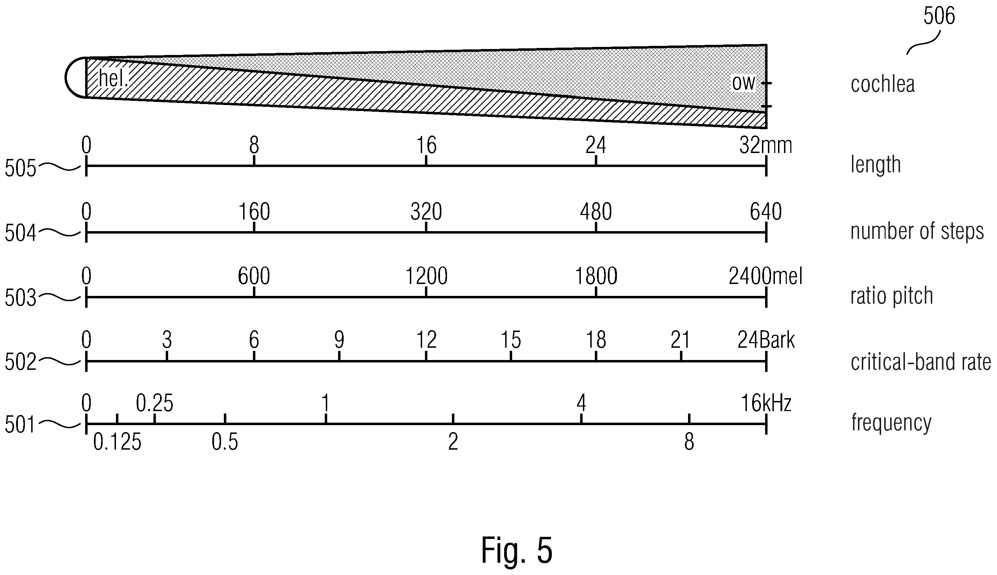

Here, the important task of frequency separation may be performed: different tones cause different regions of the basilar membrane to vibrate. Which frequencies are transferred to and concentrated at which area of the basilar membrane is exemplarily shown in figure 5 [2].

Fig. 5 shows a schematic drawing of the relation between the critical-band rate, location on the basilar membrane, and frequency of a tone (retrieved from [2]). Fig. 5 shows a relation between a frequency, a critical-band rate 502, a ratio pitch 503, a number of steps 504, and a length 505 of the basilar membrane (hel. = Helicotrema, ow = oval window). Length 505 may represent a place of a maximum stimulation for a respective frequency.

In this figure, it is visible that the spectral analysis performed in the cochlea 506 has a frequency dependent selectivity often described by critical bandwidth. According to an aspect of the invention, the frequency separation mechanism of the human ear is imitated, for example, by an All-pole gammatone filterbank. This will be further explained in the following section.

Another example of a mechanism of the basilar membrane which may be used in this project is the effect of one sound being made inaudible by another sound. This so-called masking effect can be experienced in many situations of the daily life. For example, the sound of a car engine may be masked by music from the car's radio. Masking has been defined as the process by which the threshold of audibility for one sound is raised by the presence of another (masking) sound [3]. The threshold of audibility of a sound in the presence of a masking sound is called masked threshold. It is the sound pressure level of a test sound which is necessary to be just audible in the presence of a masker. In nearly all cases this masked threshold lies above the threshold in quiet. If the frequencies of the masker and the test tone are very different, the masked threshold and the threshold in quiet are identical [2]. There are multiple ways to achieve a masking effect: Firstly, the masker and the test sound may be played at the same time. An example for this would be an orchestra, in which a loud instrument might mask another instrument which remains faint. This is called simultaneous masking. Secondly, the test sound could be played before or after the masker, which would be classified as non-simultaneous masking. In this case the test sound has to be a short burst or sound impulse. While no strong masking effects can be measured if the test sound is presented before the masker is switched on (premasking), pronounced effects occur if the test sound is presented after the masker is switched off (postmasking) [2].

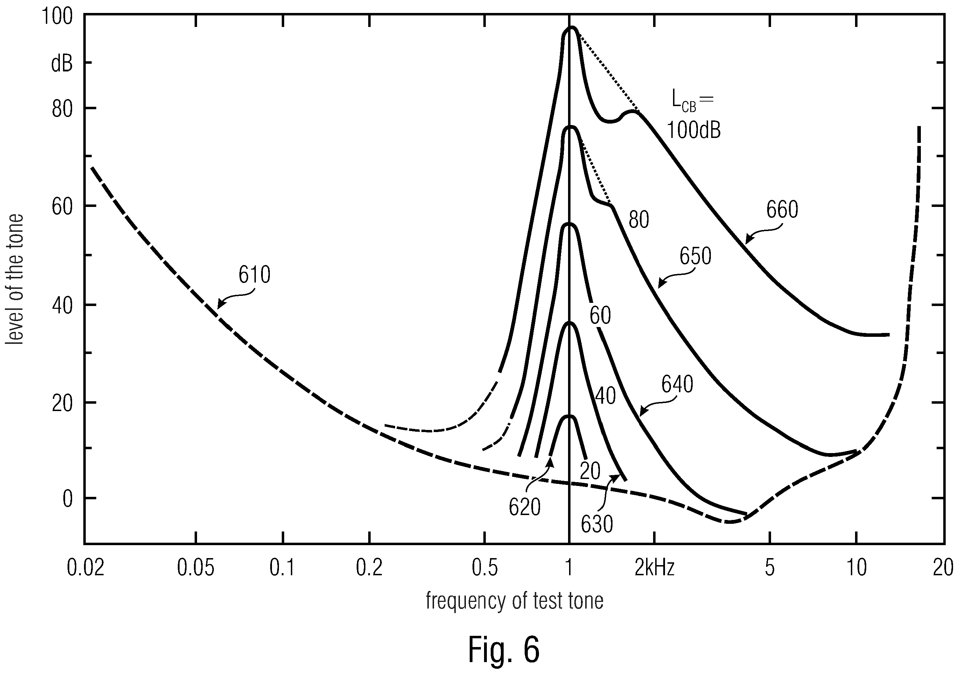

For simultaneous masking, maximum masking is usually obtained if both signals have the same center frequency. This is shown exemplarily in Figure 6, where masking curves for simultaneous masking are portrayed.

Fig. 6 shows a schematic plot of a level of test tone in dB over a frequency of test tone and corresponding masking thresholds. Dashed line 610 may represent a threshold in quiet and respective lines 620, 630, 640, 650 and 660 may represent respective masking thresholds as caused by critical-band wide noise with a center frequency of 1 kHz and a level of 20, 40, 60, 80 and respectively 100 dB. Hence, in particular, Fig. 6 shows an example of level of test tone just masked by critical-band wide noise with center frequency of 1 kHz and different levels as a function of the frequency of the test tone (retrieved from [2]).

The figure shows an example of the dependence of the masked threshold of a test tone on the level of noise centered at 1kHz. Here, it is clearly visible that for all levels of noise the masking effect increases the closer the frequency of the test tone gets to the center frequency of the noise [2]. The biggest masking effect can thus be achieved if masker and test sound both have frequencies in the same critical band. In this work, simultaneous masking effects may be used, for example, to optimize the quantizer step sizes of the audio encoder.

Referring to Fig. 6, as an example, the determination of the masking threshold information, e.g. as explained in the context of Fig. 3, may be performed so that in sections wherein the threshold in quiet 610 is above a threshold caused by the audio signal itself, e.g. a test tone within the audio signal, the threshold in quiet is considered for the selection of the quantization step size (e.g. the region approx. below 0.2 kHz and approx. above 15 kHz in Fig. 6 for $L_{CB}$ = 100dB; in other words, for 100 dB, the crossover between masking threshold and threshold in quiet may be between 10 and 20 kHz) and in sections wherein the threshold as obtained by a respective threshold analyzer, e.g. 100, 200, is above the threshold in quiet 610, the obtained masking threshold may be considered for the quantization (e.g. as a scaling factor for the quantization).

All-pole gammatone filter

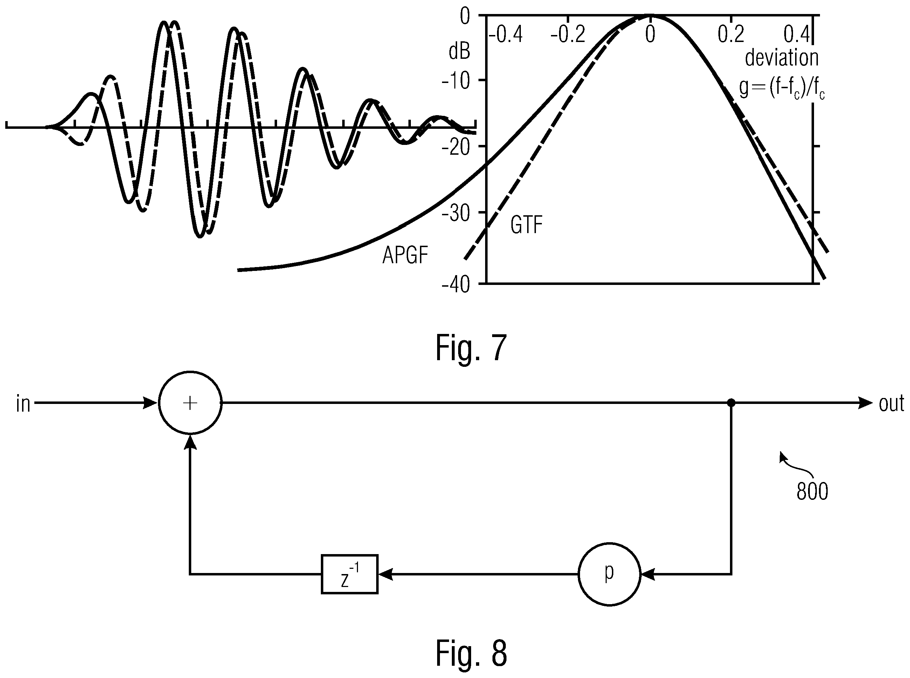

Reference is made to Fig. 7. Fig. 7 shows schematic examples of impulse response (left) and magnitude transfer function (right) of Gammatone filter (GTF) and All-pole gammatone filter (APGF) comparison (retrieved from [4]), according to embodiments.

A gammatone filter (GTF) may be defined in the time domain by the multiplication of a sinusoidal signal with a gamma distribution:

$$g(t) = At^{N-1} exp(-bt)cos(\omega_r t + \phi)$$

Because of this simple description gammatone filters provide, for example, the possibility of an efficient digital or analog implementation. Even though the basic gammatone filter is very popular, it may have limitations as a basilar membrane model. Firstly, the magnitude transfer function of the GTF is inherently nearly symmetric as shown in Fig. 7, while measurements show that the auditory filter has a significant asymmetry. Secondly, the parameterization of the GTF can be difficult to use to realistically model, for example, level dependent changes in the auditory filter [4] [5].

A filter that provides a closer time-domain match to basilar membrane mechanical impulse measurements is, for example, the All-pole gammatone filter (APGF), a close relative of the GTF. The APGF is defined by simply discarding the zeros from a pole-zero decomposition of a basic GTF. And a complex valued APGF may be obtained, for example, by additionally discarding the poles with negative imaginary parts. In the resulting impulse responses the cosine terms may then be replaced by complex exponentials.

$$GTF : \frac{Y}{X} = \frac{\epsilon_z}{\epsilon_p} \qquad\qquad APGF : \frac{Y}{X} = \frac{1}{\epsilon_p}$$

$\varepsilon_z$= zeros of the pole-zero decomposition , $\varepsilon_p$ = poles of the pole-zero decomposition

Therefore, the APGF does not have the simple time-domain description of the GTF. Still, the APGF has several properties that make it attractive for applications in auditory modeling. Firstly, the APGF shows a realistic asymmetry in the frequency domain, other than the GTF. The impulse response and the magnitude transfer function of a APGF and a GTF in comparison are shown exemplarily in Fig. 7. Secondly, the APGF may have an even more efficient implementation and a simpler parameterization than the GTF. Also, the APGF is suitable for a range of nonlinear and parametric applications that may not be well addressed by the GTF because the low-frequency tail of the APGF is unaffected by the bandwidth parameter [4].

Hence, it is to be noted that according to embodiments, at least one of the plurality of filters comprises an all-pole gammatone filter, wherein zeros from a pole-zero decomposition of a basic gammatone filter are discarded and optionally, poles with negative imaginary parts are additionally discarded.

Accordingly, in general, filters of a filterbank according to embodiments may be chosen to have an asymmetric transfer function, as shown in Fig. 7 for the case of the All-Pole-Gammatone filterbank. In particular, the filterbank may be a complex-valued All-Pole-Gammatone filterbank.

Reference is made to Fig. 8. Fig. 8 shows a schematic block diagram of an example of one filtering operation as implemented according to embodiments, e.g. as implemented in the project.

Fig. 8 shows one example of one filtering operation of the APGF that may be implemented in this project (e.g. according to embodiments). This filtering "loop", e.g. 800, is, for example, executed for every band respectively, for example, with the band specific pole value p. The order N of the filter, for example, determines how often this filtering operation is executed per band. Feedback may be used in the filtering operation, therefore making it, for example, an IIR filter. The filtering operation portrayed in Fig. 8 can, for example, also be shown through the following equation (wherein X may represent an input in and Y an output out, e.g. in z-domain):

$$Y(z) = X(z) * \frac{1}{(1 - pz^{-1})^N}$$

In this project, All-pole gammatone filters, for example, with the order N = 6 may be used. Because the purpose of the APGF filterbank is to mimic the frequency separation mechanism of the inner ear, the filterbank characteristics may be based on the Bark scale. The Bark scale was, for example, approximated using the following equations:

$$B_n = \frac{26.81 * f}{1960 + f} - 0.53 \qquad\qquad B_w = \frac{52548}{B_n^2 - 52.56 * B_n + 690.39}$$

$B_n$ = approximation for mapping from frequency to Bark number, $B_n$ = approximation for mapping from frequency to Bark width, f = frequency.

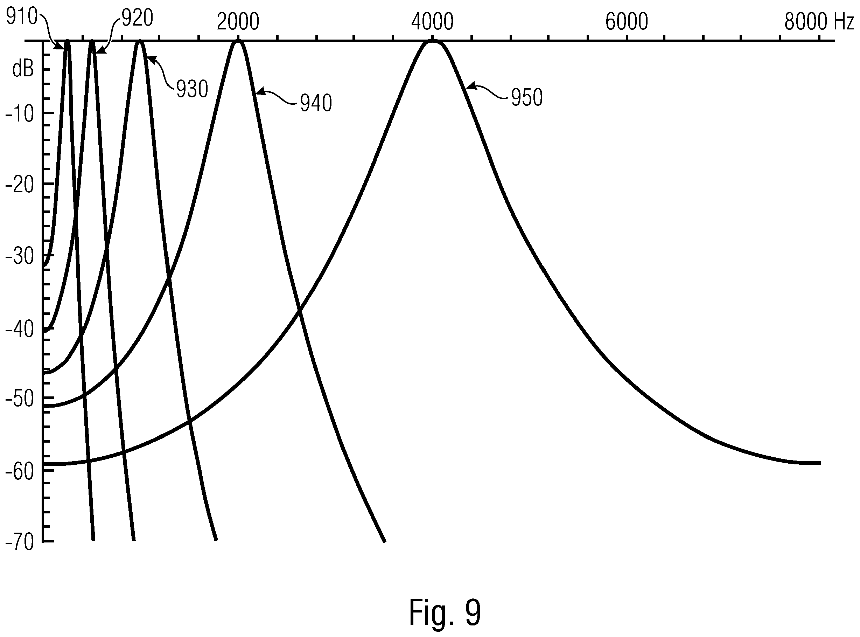

Reference is made to Fig. 9. Fig. 9 shows a schematic plot of examples of frequency responses, e.g. 910 to 950, of all-pole gammatone filters according to embodiments.

As an example, a according to embodiments or the filterbank comprises or consists, for example, of 96 bands with a frequency resolution of, for example, 4 bands per Bark. Examples of the frequency response of an APGF filterbank are shown in Fig. 9. Here it is visible that, the same as in the inner ear, for lower frequencies the bandwidths of the filters may be very small in comparison to the filter bandwidths for high frequencies (see the example in figure 5 for comparison). The maximum center frequency of the filters $f_c$ was, for example, set to 20000 Hz, the factor of the bandwidth in relation to the critical bandwidth was, for example, set to 0.25. This may yield much smaller bandwidths (for example, the 3 dB bandwidths may be all below one quarter of a Bark, while in standard settings they would maybe be in a range between half a Bark and one Bark) and, for example, much steeper slopes of the filters in comparison of those used in gammatone filterbanks for directly modeling masking effects without, for example, additional spreading of the filter outputs. While the slopes of masking thresholds around tonal or narrowband maskers are maybe in the range of 20 to 30 dB per Bark, here the attenuations at frequencies one Bark above or below the center frequencies, for example, reach between 50 and 80 dB (the filters with very high center frequencies, for example, show the lower attenuations).

To align the outputs of the different filterbank bands the group delay of every band was, for example, calculated dependent on, for example, the respective center frequency. This group delay was, for example, then weighted and stored as, for example, the look-ahead for every band respectively. For the ratio of the look-ahead to the group delay of the filters a factor of 0.7 was, for example, chosen.

Frequency domain Spreading

The decomposition of the masking sound spectrum into simple masker components is, for example, performed by the All-pole gammatone filterbank. The filterbank outputs are then, for example, smeared out over frequency to result, for example, in the overall masked threshold. This spreading or superposition can be implemented linear or nonlinear. Psychoacoustic measurements have shown that linear addition of masker components often results in a much lower overall threshold than determined experimentally, while nonlinear superposition matches the measured thresholds more closely [6]. Also, the nonlinear spreading aims to mimic the nonlinear behavior of the ear in the processing of sound. As the filterbank may yield complex valued outputs, the (nonlinear or linear) spreading can, for example, be performed using, for example, only the magnitude values of the filterbank outputs or using the complex values. Because the All-pole gammatone filters are, for example, IIR filters with a nonlinear phase response, a phase correction factor may be implemented for (nonlinear and linear) spreading with complex values. Also, the group delay of each filter, which is defined as the derivation of the phase response, may be taken into consideration. This will be further explained in the following section.

Hence, it is to be noted that an the masking threshold determinator according to embodiments may be configured to obtain a masking threshold information associated with a given frequency region on the basis of magnitudes of the bandpass signal values of the at least two bandpass signals.

Phase correction

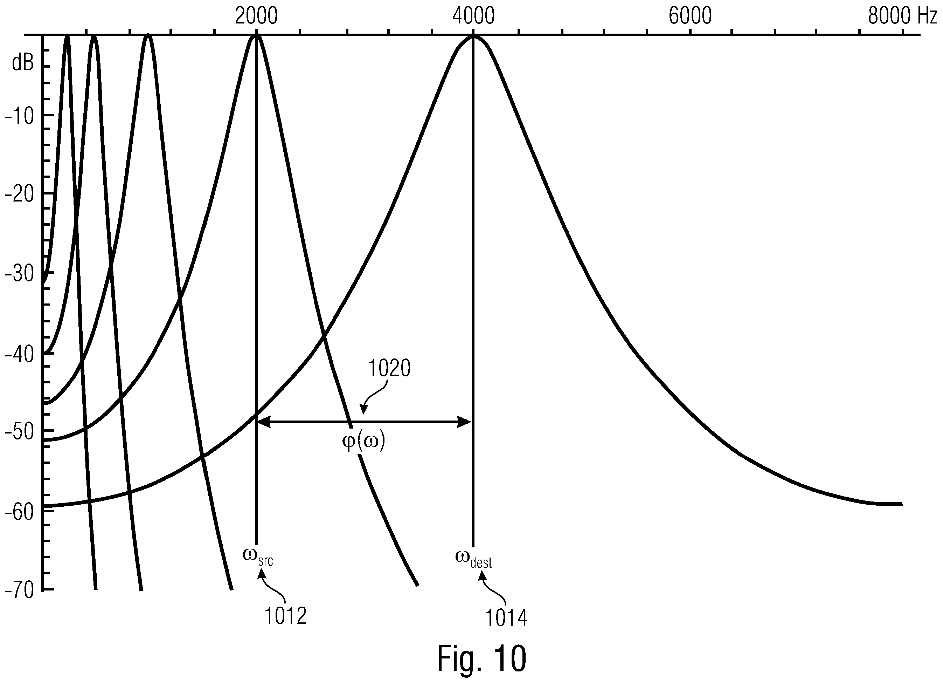

Reference is made to Fig. 10. Fig. 10 shows a schematic plot of an example of a first approach to estimate the phase shift between two filterbank bands src (e.g. source) and dest (e.g. destination) using only the center frequencies, according to embodiments.

The first approach to correcting the phase shift for complex spreading was to calculate, for example, the phase difference, for example, between the center frequencies of all filterbank bands, e.g. as shown as an example, differences φ (ω) 1020 of center frequencies 1012, 1014. This is visualized exemplarily in Fig. 10. The idea was to calculate, for example, the phase shift for all bands in respect to all other bands, resulting, for example, in a matrix with rows and columns of the number of filterbank bands. For example, in this matrix the row index indicated the column index of the source band in that row and all other indexes of that row, for example, contain the phase shift from the source band to the destination band. To calculate the phase shift of the source band to the destination band the following equation for the phase response $\varphi(\omega)$ using the filter poles and zeros may be used:

$$\varphi(\omega) = arg(G) + \sum_{m=1}^{M} arg(e^{j\omega} - z_{0,m}) - \sum_{n=1}^{N}(\omega_c - arg(e^{j\omega} - z_{\infty,n})) \qquad (1)$$

N = amount of poles, M = amount of zeros

Because the APGT does not contain any zeros, this equation can be reduced to:

$$\varphi(\omega) = \sum_{n=1}^{N}(\omega_c - arg(e^{j\omega} - z_{\infty,n})) \qquad (2)$$

$$\varphi(\omega) = O * (\omega_c - arg(e^{j\omega_c} - z_{\infty})) \qquad (3)$$

Here, $\omega_c$ is the center frequency of the source band, $z_{\infty,n}$ is the pole of the destination band, and O is the order of the APGF filterbank. Because every band of the APGF contains one band specific pole value as many times as the order of the filter indicates, equation (1) can be simplified to equation (3). The approach of using the center frequencies of the bands to calculate the phase shift was less successful because, for example, the phase difference between the center frequencies of two adjacent bands in the used APGF filterbank is often quite big and can even be close to $\pi$. When calculating the phase shift, for example, using the phase response of equation (1) or (3), a phase difference of $\pi$ in two adjacent bands leads to the bands canceling each other out. Therefore, this approach did not yield useful results.

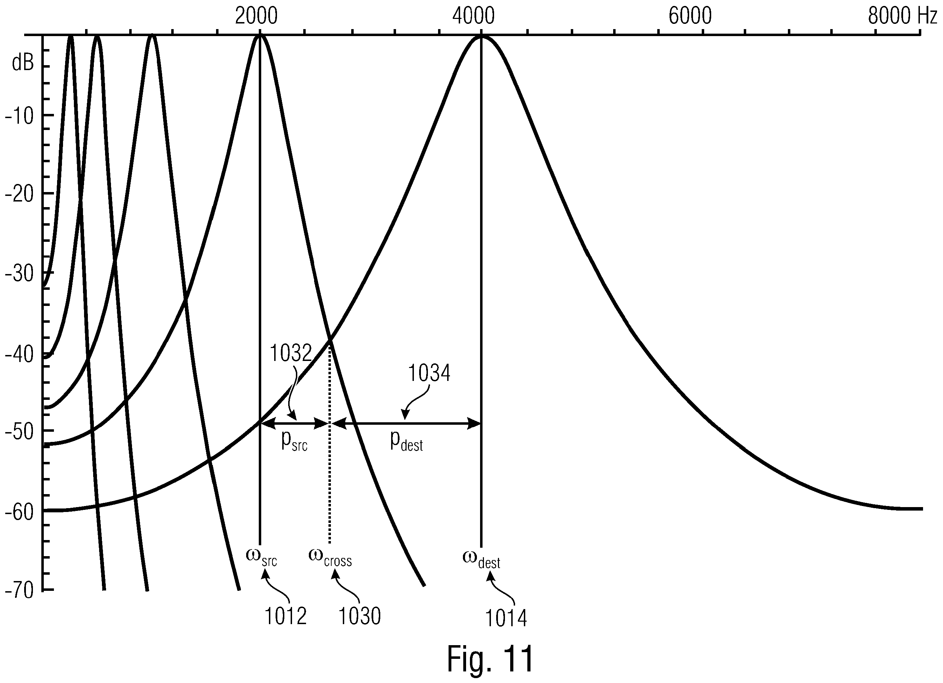

Reference is made to Fig. 11. Fig. 11 shows a schematic plot of an example of a second approach to estimate the phase shift between two filterbank bands src and dest using the crossing frequency of the bands, according to embodiments.

To solve this problem, in the second approach to calculate the phase shift, for example, the frequency of the bands estimated crossing point, e.g. 1030, was used instead of the center frequency (Fig. 11). Because this approach may, for example, only use adjacent bands as the source and destination band for the phase shift, the result is, for example, not a matrix as in the previous approach but instead, for example, a vector with one phase correction value for every band. This overall phase correction value is calculated, for example, using the phase shift, e.g. 1032, between the pole of the source band and the crossing frequency and the phase shift, e.g. 1034, between the pole of the destination band and the crossing frequency. The frequency of the crossing point of the two adjacent bands is coarsely approximated, for example, as follows:

$$\omega_{cross} = \omega_{src} + \frac{u}{1+u} * (\omega_{dest} - \omega_{src}) \qquad (4)$$

$W_{src}$ = center frequency of the source band, $W_{dest}$ = center frequency of the destination band, u = upper spreading factor.

The phase shift between respectively the source band and the destination band and the crossing point is then calculated, for example, using formula (1) or (3). Here, also the look-ahead $d_{band}$ of the respective band may be taken into account.

$$p_{band} = \varphi_{band}(\omega_{cross}) + \omega_{cross} * d_{band}$$

which, for APGT, resolves to

$$p_{band} = O * (\omega_c - arg(e^{j\omega_{cross}} - z_{\infty,band})) + \omega_{cross} * d_{band} \qquad (5)$$

$p_{band}$ = overall phase response of the source or destination band at the crossing frequency $\omega_{cross}$, $z_{\infty,band}$ = pole of the band source or destination, and e.g. $d_{band} = 0.7 * \tau_g(\omega_{band})$ with $\tau_g(\omega_{band})$ being the group delay at the center frequency of the respective band.

The overall phase correction value is then calculated, for example, as:

$$Z_{corr} = e^{j*(p_{dest}-p_{src})} \qquad (6)$$

The correction values may be calculated for all bands, for example, for both upward and downward spreading. In the case of upward spreading the destination band is, for example, the band adjacent to the source band with the next larger index, in the case of downward spreading the destination band is, for example, the band adjacent to the source band with the next smaller index.

Linear spreading

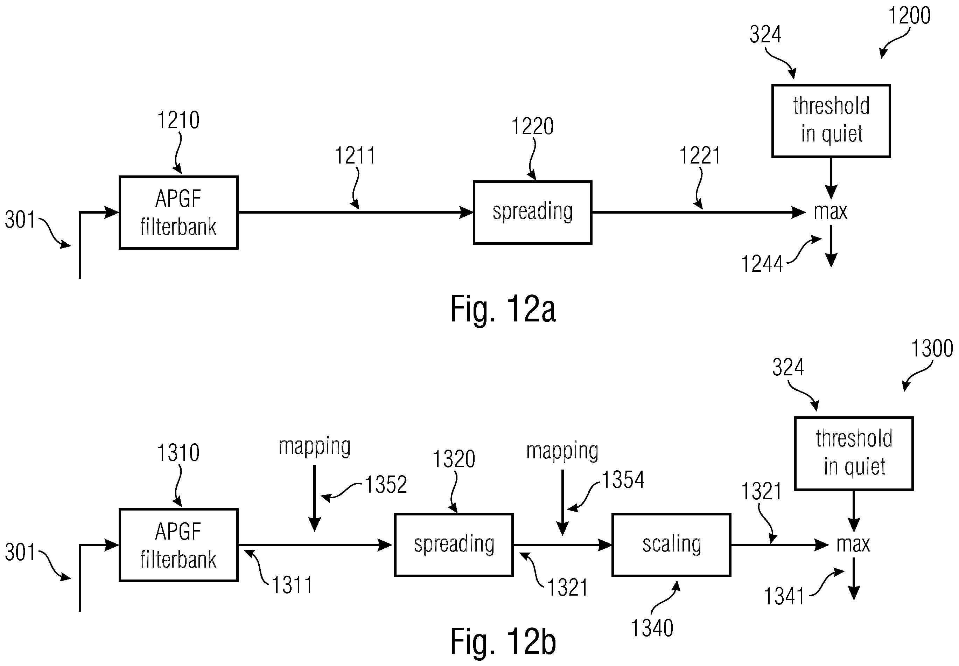

Reference is made to Fig. 12a. Fig. 12a shows a schematic block diagram of a linear spreading pipeline according to an embodiment of the invention. Fig. 12a shows a masking threshold determinator 1200 comprising a filterbank 1210 and an optional spreading unit 1220. As further optional feature, threshold determinator 1200 is configure to perform a comparison of a threshold in quiet and a masking threshold 1221 as obtained by spreading unit 1220, in order to determine a masking threshold information 1241.

In one example of a linear spreading operation, the output value, e.g. a value of bandpass signals 1211, of one filterbank band is, for example, weighted by a spreading function and then added, for example, to its neighboring bands. The spreading function is, for example, a two sided exponential, meaning that going upwards and going downwards from the source band, the weighted value of the source band that gets added to the destination band gets, for example, exponentially smaller the further away the destination band is from the source band. The linear spreading implemented in this project is, for example, based on the pseudo code published in [7]. One change that was made in this project as compared to the code suggested in [7] is that, for example, the upward and downward spreading functions both are implemented as level independent and thus for the upper and the lower slope of the spreading function, for example, constant values were used. The upper slope $s_u$ was, for example, set to 20dB and the lower slope $s_l$ was set, for example, to 31dB.

The upward spreading factor u and the downward spreading factor l are, for example, defined in the following. The defined amount of filterbank bands per one bark is represented by the letter $\beta$.

$$u = 0,1^{\frac{s_u}{\beta * 20}} \qquad\qquad l = 0,1^{\frac{s_l}{\beta * 20}}$$

The upward and downward spreading functions are thus defined, for example, as $u^x$ and $d^x$. The spreading is, for example, implemented as:

$$y_b = x_b + \sum_{k=0}^{b-1} x_k u^{b-k} + \sum_{k=b+1}^{B-1} x_k l^{k-b} \qquad \forall b, 0 \le b \le B-1 \qquad (7)$$

x = spreading input, y = spreading output, u = upper spreading factor, l = lower spreading factor, B = number of bands.

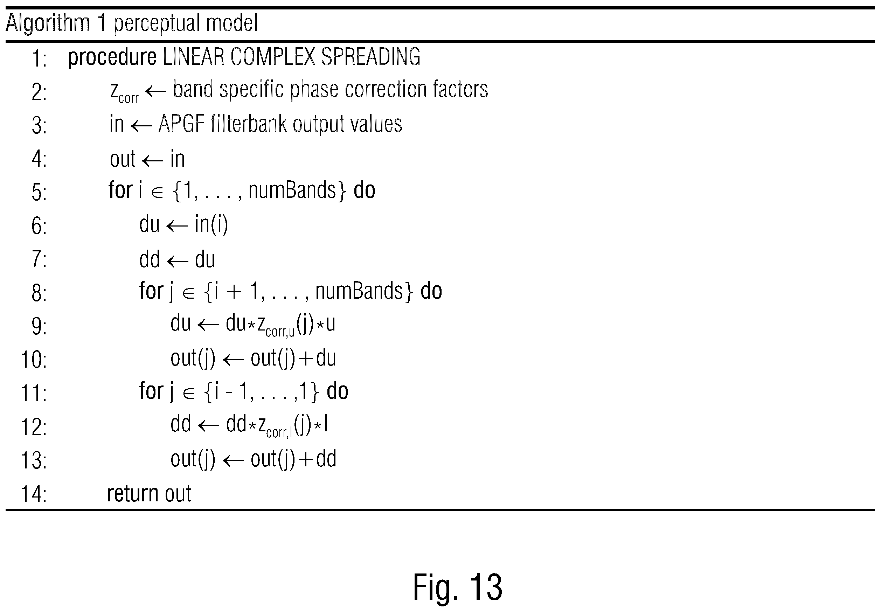

For magnitude linear spreading the spreading input x is, for example, the magnitude value of the filterbanks complex output. If complex linear spreading is performed the complex filterbank output is, for example, used as the input x. As previously mentioned, because of the nonlinear phase response of the APGF filter a phase correction may be added to the algorithm. The linear complex spreading can, for example, be described through the pseudo code shown in Fig. 13 (Algorithm 1).

Nonlinear spreading

Reference is made to Fig. 12b. Fig. 12b shows a schematic block diagram of an example of a nonlinear spreading pipeline according to embodiments. Fig. 12b shows a masking threshold determinator 1300 comprising a filterbank 1310 (as an example, an APGF filterbank) and an optional spreading unit 1320. As further optional feature, threshold determinator 1300 is configured to perform a comparison of a threshold in quiet 324 and a masking threshold 1321, in order to determine a masking threshold information 1341. In addition, masking threshold determinator 1300 comprises a scaling unit 1340 and the masking threshold determinator 1300 is configured to perform mappings 1352 and 1354

A non-linear spreading operation follows, for example, the same concept as a linear spreading operation. The difference between linear and nonlinear spreading is, for example, that the nonlinear model uses, for example, a compressive exponential characteristic prior to the addition of masker components [6]. This means, for example, that first, the input value is mapped to the nonlinear domain, then, for example, spreading is performed, for example, with a spreading factor that is adapted to the nonlinear domain. The resulting value is then, for example, mapped back to the linear domain. Similar to linear spreading, nonlinear spreading can either be performed, for example, on the complex output values of the filterbank 1310, e.g. APGF filterbank, or only, for example, on the magnitudes of those outputs. If nonlinear magnitude spreading is performed, the mapping, e.g. 1352, to the nonlinear domain can, for example, be implemented as follows for the output values of all filterbank bands, e.g. 1311:

$$|x_{nl}| = |x|^{\alpha} \qquad (8)$$

x = spreading input, $\alpha$ = nonlinear spreading factor, $x_{nl}$ = spreading input in the nonlinear domain.

In the nonlinear domain, the spreading is performed, for example, the same way as in linear spreading (see equation 7). Here, similarly to the spreading input value, the upper and lower spreading factors both, for example, may be mapped in the nonlinear domain:

$$u_{nl} = u^{\alpha} \qquad\qquad l_{nl} = l^{\alpha}$$

$$(11)$$

The spreading is then, for example, performed analogous to equation 7, for example, with $x_{nl}$ as the spreading input, $u_{nl}$ as the upper spreading factor and $l_{nl}$ as the lower spreading factor. The spreading output value $y_{nl}$ then, for example, may be mapped back into the linear domain, for example, to result into the final spreading output y. Because the nonlinear spreading yields very big results with a nonlinear exponent value of, for example, $\alpha = 0.3$, additionally to the mapping, the spreading output value $y_{nl}$ may be scaled down, for example, using the scaling factor $s_{nl,mag}$. This is just an empirically found scaling which takes into account, for example, $\alpha$ and the ratio of the bark width of the first filterbank band to the band width of the concerning band.

$$s_{nl,mag} = \alpha^{5.1} * \left(\frac{B(\omega_{c,0})}{B(\omega_{c,b})}\right)^{0.2} \qquad |y| = s_{nl,mag} * |y_{nl}|^{\frac{1}{\alpha}} \qquad (9)$$

$\alpha$ = nonlinear exponent, $\omega_{c,b}$ = center frequency of filterbank band b, $B(\omega)$ = Bark width of frequency $\omega$, I y I = spreading output mapped back into the linear domain.

If nonlinear spreading is performed, for example, on complex values and not only on the magnitudes of the filterbank outputs, the mapping from the linear into the nonlinear domain may be adapted. Here, it may be taken into account that, for example, only the magnitude of the complex value may be mapped into the nonlinear domain, for example, while the phase remains unchanged:

$$x_{nl} = |x|^{\alpha} * e^{arg(x)i}$$

$$x_{nl} = |x| * e^{arg(x)i} * \frac{|x|^{\alpha}}{|x|}$$

$$x_{nl} = x * |x|^{\alpha-1}$$

Then the spreading is performed, for example, similarly to equation 7, again using, for example, upper and lower spreading factors that are, for example, also mapped to the nonlinear domain as shown in equation 11. The phase correction values (e.g. as explained in the context of Fig. 2) are, for example, also mapped to the nonlinear domain. Finally, the spreading output value for nonlinear complex spreading $y_{nl}$ (e.g. 1321) also may be mapped back, e.g. 1354, to the linear domain and, for example, scaled with the factor $s_{nl,c}$, e.g. using optional scaling unit 1340. This is again an empirically found scaling:

$$s_{nl,c} = \alpha^3 * \left(\frac{B(\omega_{c,0})}{B(\omega_{c,b})}\right)^{0.2} \qquad\qquad |y| = s_{nl,c} * y_{nl} * |y_{nl}|^{\frac{1}{\alpha - 1}} \qquad (10)$$

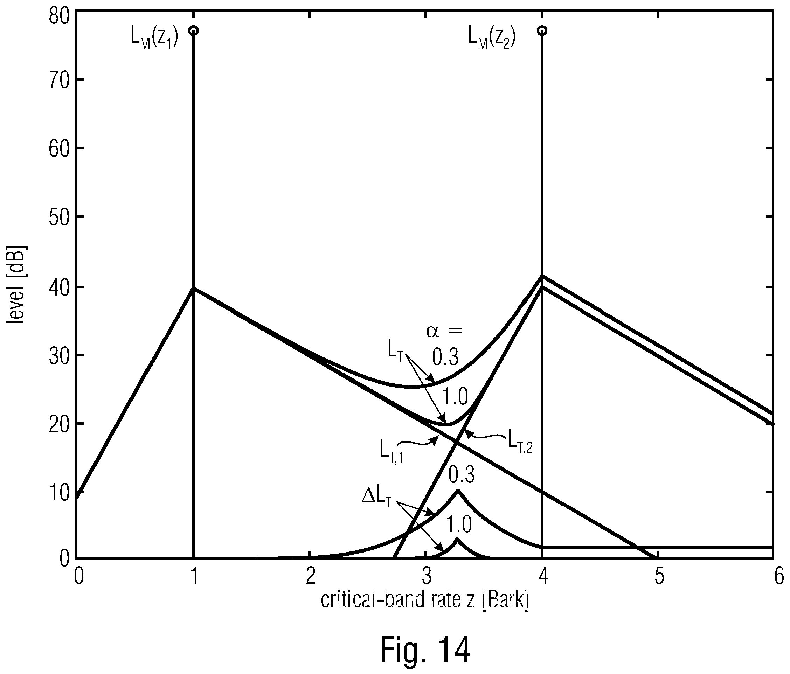

Reference is made to Fig. 14. Fig. 14 shows a schematic plot of an example of nonlinear superposition of two masked threshold components $L_{T,1}$ and $L_{T,2}$ resulting in the overall threshold $L_T$ (retrieved from [6]). The components are plotted for a critical band rate z (in Bark) over a level in dB.

The influence of different values for the nonlinear exponent $\alpha$ in nonlinear spreading is, for example, shown in Fig. 14. In the figure, the resulting additional masked threshold level after applying nonlinear spreading with the respective nonlinear exponent value is shown, for example, via $\Delta L_T$. If $\alpha$ is set, for example, to 1.0, the spreading output of the nonlinear model equals the output of linear spreading. Fig. 14 thus shows exemplarily that the linear spreading model only leads, for example, to a maximum threshold increase of 3dB, while the nonlinear model with a nonlinear exponent value of, for example, $\alpha = 0.3$ leads to a maximum threshold increase of, for example, 10dB [6] (see e.g. $\Delta L_T$).

Results

The performance of the different spreading functions that were applied, for example, to the APGF filterbank output were tested using, for example, multiple noise and tonal input audios. The audios were first separated into their frequency components, for example, by the APGF filterbank, then a spreading function was applied to this output. Here, a sampling rate of, for example, 48 kHz was used. The spreading output was then used, for example, to calculate the masked threshold of the input sample, which was then used, for example, to alter the quantizer step size of the encoder. To plot the result the encoded signal was again decoded and/or analyzed.

In this project the following examples of spreading functions were implemented and tested:

- Linear magnitude spreading
- Linear complex spreading
- Nonlinear magnitude spreading
- Nonlinear magnitude spreading

Time resolution

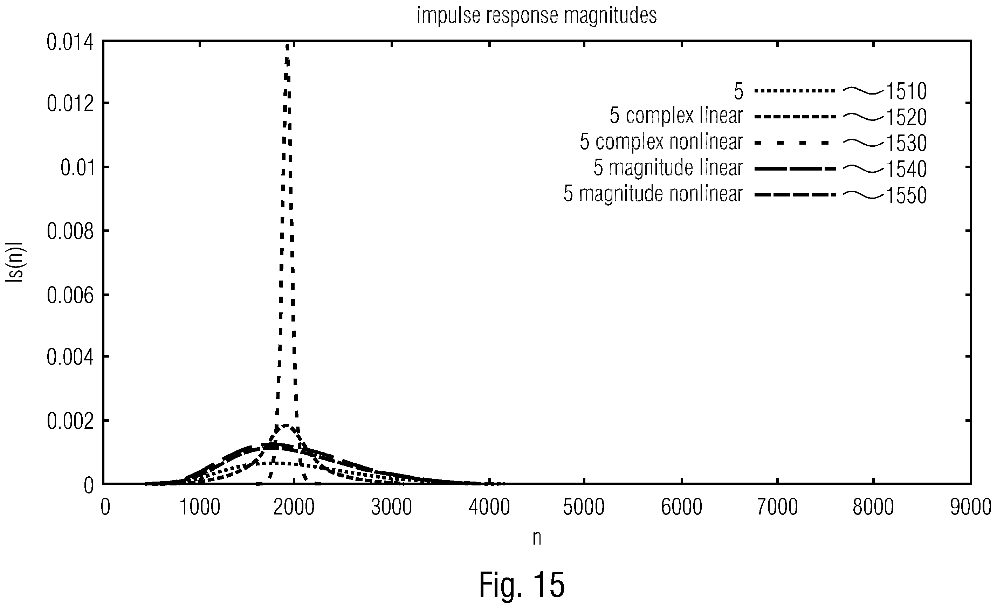

Reference is made to Fig. 15. Fig. 15 shows a schematic plot of an example of impulse response magnitudes of filterbank band 5 for nonlinear, linear, and no spreading, according to embodiments of the invention. The magnitudes of the respective impulse response, |s(n)| is plotted over samples n.

In Fig. 15 the impulse response magnitudes after performing, for example, complex linear spreading, e.g. 1520, magnitude linear spreading, e.g. 1540, complex nonlinear spreading, e.g. 1530, magnitude nonlinear spreading, e.g. 1550, and no spreading, e.g. 1510, are shown. In the plot it is visible that the time resolution of the magnitude response does not significantly change after applying, for example, magnitude linear or magnitude nonlinear spreading (the blue, e.g. 1540, and yellow, e.g. 1550, lines in the plot), as it yields a very similar response compared to, for example, when no spreading is applied. While magnitude spreading may not yield an improved time resolution, the complex linear spreading (purple, e.g. 1520) results, for example, in a more compact peak and therefore a better time resolution than when, for example, no spreading is applied. The improved time resolution for complex spreading is even more visible for complex nonlinear spreading (green, e.g. 1530), as it has an even more compact peak as the plot for complex linear spreading.

Magnitude response

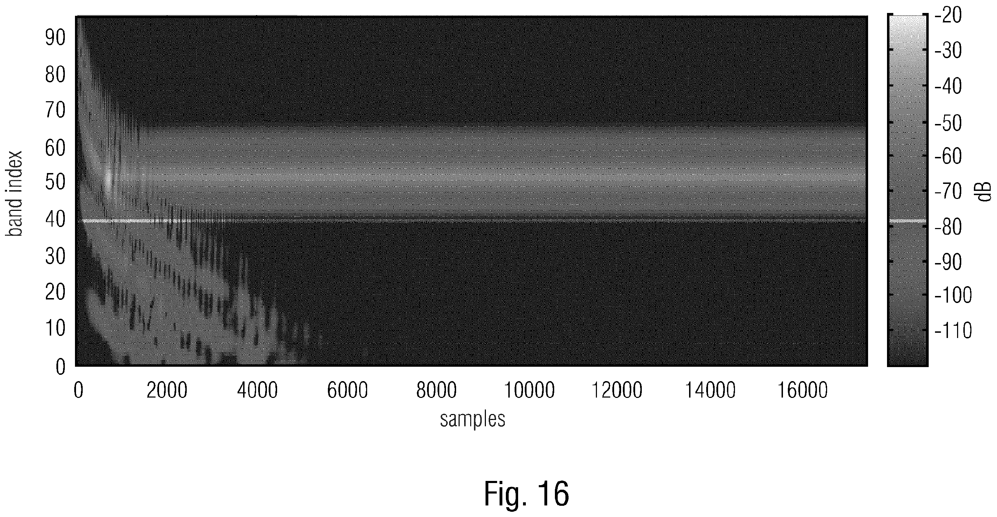

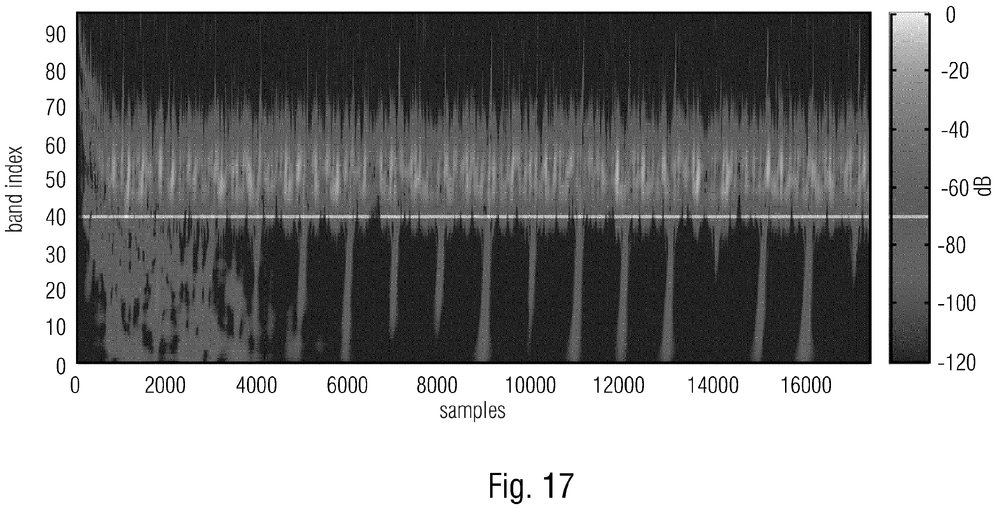

Reference is made to Fig. 16 and 17. Fig. 16 shows a schematic plot of an example of a spectrogram of the magnitude response of an APGF filterbank using an input sine signal after complex nonlinear spreading according to embodiments of the invention. Fig. 17 shows a schematic plot of an example of a spectrogram of the magnitude response of an APGF filterbank using an input 2 bark narrowband noise signal after complex nonlinear spreading according to embodiments of the invention.

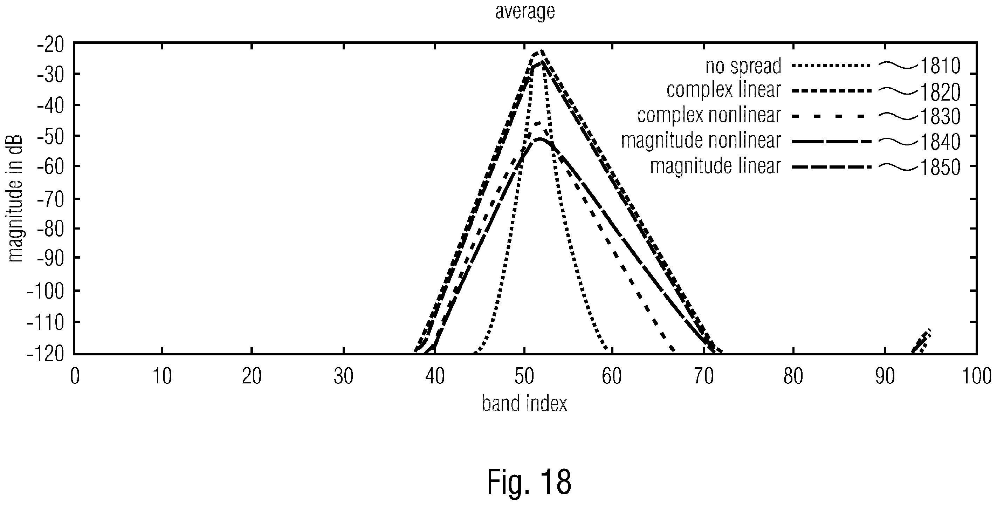

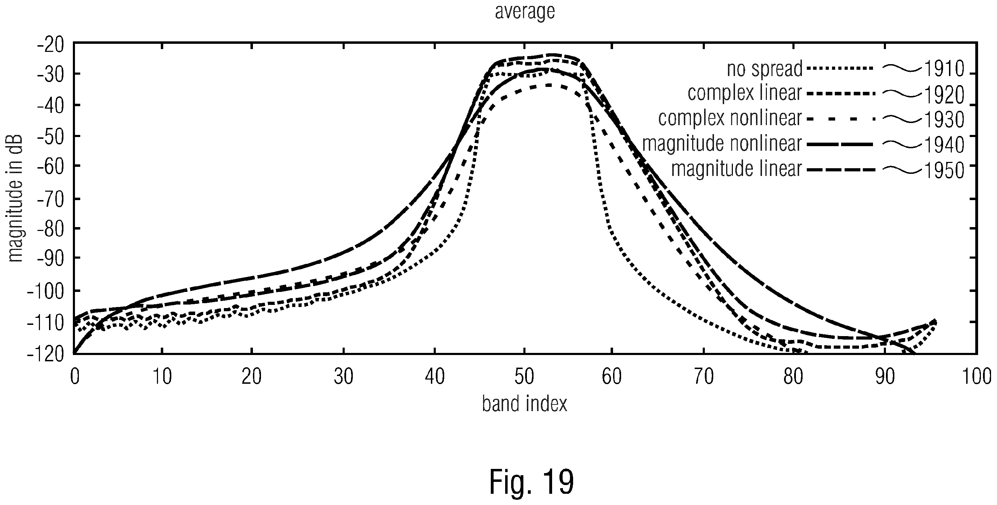

To show the magnitude response of the All-pole gammatone filterbank for input noise and sine signals, spectrogram plots were used. For Fig. 16 and 17 a sine signal and a narrowband noise signal with, for example, 2 bark were processed sample wise. Both input audios had frequencies of, for example, 2 kHz and were, for example, 20000 samples long. In Fig. 16 and 17 the transient response of the processed audios can be seen for the samples in the range 0 to 6000. In the two plots it is already visible that the noise signal has a broader magnitude response than the sine signal and that the nonlinear spreading may yield bigger results for the noise signal than for the sine signal. The periodic vertical lines visible in Fig. 17 are caused by the way the noise was generated and not by the processing in the model. For a more detailed comparison of all spreading functions, for example, for a sine and a noise input signal see e.g. section, example temporal/spectral magnitude responses. To visualize the influence of different spreading functions on the input audios better, the average magnitude values for the whole signal was calculated and plotted for all spreading functions. This is exemplarily shown in Fig. 19 and 18.

Reference is made to Fig. 18. Fig. 18 shows a schematic plot of an example of normalized average magnitudes using sine signal input according to embodiments of the invention. Magnitudes in dB are plotted over band indices.

Fig. 18 shows an example of the normalized average magnitude response of the APGF filterbank for a sine signal after applying, for example, complex linear spreading, e.g. 1820, complex nonlinear spreading, e.g. 1830, magnitude linear spreading, e.g. 1850, magnitude nonlinear spreading, e.g. 1840, or no spreading, e.g. 1810. The used sine signal had a frequency of, for example, 2kHz and contained, for example, 20000 samples. The audio file was, for example, processed sample wise. For the average magnitude plot only the steady state part of the input audio was taken into consideration, therefore only the samples in the range, for example, 8000 to 16000 were used. In the plot it is clearly visible that the maximum of all average magnitude functions lies closely above, for example, filterbank band 50. At the band that corresponds to the peak of the average magnitude functions, for example, the center frequency should be the closest to the frequency of the input audio. Also, Fig. 18 shows the influence of different spreading functions on the average magnitude response of the APGF filterbank. For all exemplary spreading functions the average magnitude values are more broadly distributed over the bands than when no spreading function is applied ("no spread", e.g. 1810, in Fig. 18). The average magnitude functions for all different kinds of exemplary spreading thus have a less steep slope than, for example, the unprocessed filterbank output. Moreover it is visible that while, for example, the linear spreading functions (e.g. 1820, 1850) yield slightly bigger results than, for example, when no spreading is applied, the average magnitude (e.g. 1830, 1840), for example, of the nonlinear spreading function outputs are considerably smaller. This can be explained, for example, with the scaling that is applied after nonlinear spreading. Without the scaling, both the exemplary nonlinear magnitude and exemplary nonlinear complex spreading function yield considerably larger results than the linear spreading functions. Also it can be seen that the two exemplary linear spreading functions and the two exemplary nonlinear spreading functions respectively have a very similar output. In the example of the nonlinear spreading this is again a result of the scaling. For linear spreading this indicates, for example, that the phase correction mechanism that was implemented in the project is working.

Reference is made to Fig. 19. Fig. 19 shows a schematic plot of an example of normalized average magnitudes using 2 Bark narrowband noise according to embodiments of the invention. Magnitudes in dB are plotted over band indices. Results for no spreading are represented by plot 1910, for complex linear spreading by plot 1920, for complex non linear spreading by plot 1930, for magnitude non linear spreading by 1940 and by magnitude linear spreading by plot 1950.

For Fig. 19 a narrowband noise signal with, for example, 2 Bark was used as an input signal. The signal again contained, for example, 20000 samples of which, for example, sample 8000 to 16000 were taken into consideration for the plot. As opposed to Fig. 18, Fig.19 does not have one sharp peak as a maximum but instead a plateau in the area of the bands with the center frequencies closest to the frequencies represented in the narrowband noise. Similar to the average magnitudes for a sine signal (Fig. 18) for a noise signal all exemplary spreading functions yield a broader spectrum than when no spreading is applied (e.g. 1910). Also the average magnitude output (e.g. 1920, 1950) of, for example, the two exemplary linear spreading functions is again slightly bigger than the average magnitude without spreading (e.g. 1910). One difference between the average magnitude response of the sine signal compared to the noise signal is, for example, that all exemplary spreading functions yield very similar results for the noise signal while for the sine signal, the exemplary nonlinear spreading function results were considerably smaller than the exemplary linear spreading results.

Table 1: Examples of maximum magnitude values of the APGT filterbank output after applying complex linear, complex non linear, magnitude non linear, magnitude linear, and no spreading.

|  | No spreading [in dB] | Complex linear spreading [in dB] | Complex non linear spreading [in dB] | Magnitude non linear spreading [in dB] | Magnitude linear spreading [in dB] |
|---|---|---|---|---|---|
| Sine | -25.8359 | -22.732 | -45.6785 | -50.7278 | -26.1002 |
| Noise 1 bark | -29.6056 | -26.3332 | -37.9606 | -37.7229 | -25.7982 |
| Noise 2 bark | -28.7406 | -25.731 | -33.6539 | -28.6097 | -24.0874 |
| Noise 3 bark | -27.9669 | -25.273 | -33.4221 | -25.0583 | -23.407 |

The same can be seen in table 1: for exemplary magnitude and complex nonlinear spreading the maximum magnitude value for an input sine signal is considerably smaller than the exemplary maximum magnitude value for a narrowband noise signal with, for example, 1, 2 or 3 bark. In comparison the maximum magnitude values for exemplary magnitude linear spreading, complex linear spreading and no spreading for all noise and the sine signal all are in a very narrow range of values. This is also shown exemplary in table 2.

Table 2: Example of differences between the maximum magnitude values of the APGT filterbank output of noise signals with 1, 2, and 3 bark and the maximum magnitude values of the output of a sinus after applying different spreading functions. The value is always calculated by subtracting the maximal magnitude value of the respective spreading for the sine function from the associated maximal noise value.

| | No spreading [in dB] | Complex linear spreading [in dB] | Complex non linear spreading [in dB] | Magnitude non linear spreading [in dB] | Magnitude linear spreading [in dB] |
|---|---|---|---|---|---|
| Noise 1 bark | -3.76972 | -3.60123 | 7.71788 | 13.0049 | 0.30203 |
| Noise 2 bark | -2.90475 | -2.99903 | 12.0246 | 22.118 | 2.01281 |
| Noise 3 bark | -2.13102 | -2.54102 | 12.2564 | 25.6695 | 2.69324 |

In table 2 the difference between the maximum output values for all different exemplary spreading functions for the input sine signal and the input noise signals is shown. Here it is again visible the maximum magnitude value for the exemplary linear spreading functions and no spreading is very similar for the sine and the noise signals, the biggest difference being -3.76972 dB (Noise 1 bark with no spreading). For complex and magnitude nonlinear spreading, for example, a different behavior can be seen: the difference between the maximum magnitude values of the noise signals and the sine signal, for example, is big in comparison to the values for the other spreading functions with a maximum difference of 25.6695 dB (noise 3 bark with magnitude nonlinear spreading).

Masked threshold estimation

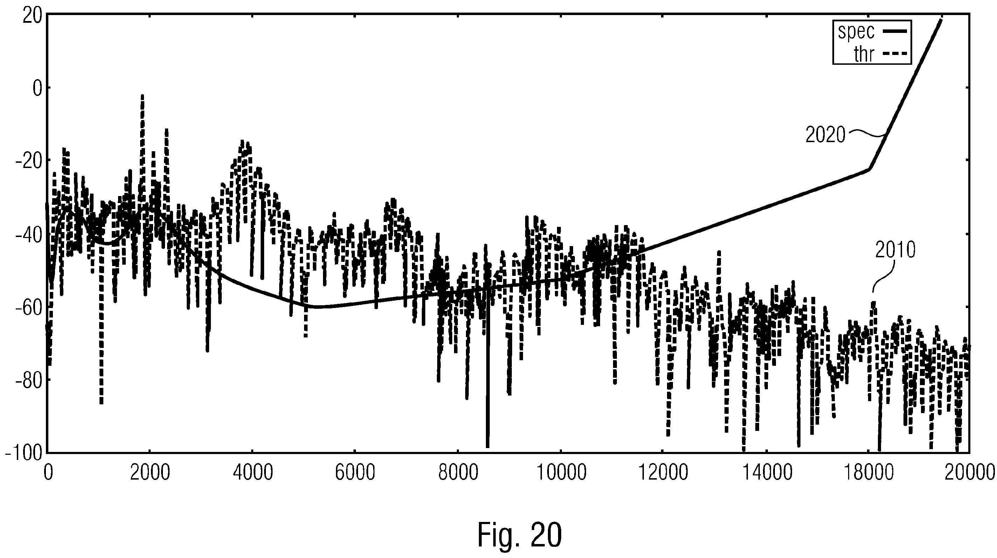

Reference is made to Fig. 20. Fig. 20 shows a schematic plot of an example of a masked threshold estimation of the perceptual model for an input audio of an orchestra according to an embodiment of the invention.
Fig. 20 shows the frequency spectrum (e.g. 2010) of a frame in an exemplary orchestra audio and the exemplary masked threshold (e.g. 2020) estimated by the psychoacoustic model. The x axis of the plot shows the frequency in Hz and the y axis shows the level of the tone in dB. It is visible that in the range of 0 to 12000 Hz, the estimated masked threshold is always lower than the frequency spectrum of the input audio file. For frequencies higher than 12000, the masked threshold is higher than the frequency spectrum of the input audio. This means that the masked thresholds estimated by the psychoacoustic model for this frequency range are lower than the threshold in quiet for these frequencies.

Listening test

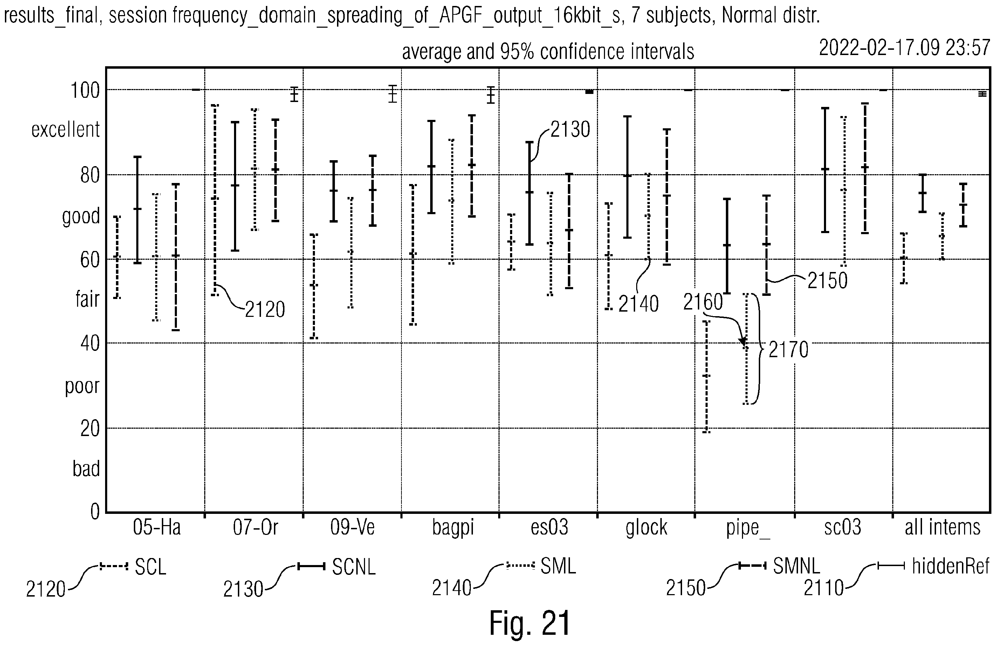

Reference is made to Fig. 21. Fig. 21 shows a schematic plot of an example of results of a WebMUSHRA listening test with 4 test items and a hidden reference (2110), according to embodiments. For the test items, different spreading functions have been used to estimate the masked threshold: SCL = complex linear spreading, e.g. 2120, SCNL = complex nonlinear spreading, e.g. 2130, SML = magnitude linear spreading, e.g. 2140, SMNL = magnitude nonlinear spreading, e.g. 2150. Note: The increased time resolution of the complex nonlinear spreading was not used in this listening test. Fig. 21 shows averages 2160 with 95% confidence intervals 2170.
To evaluate the different exemplary spreading methods (nonlinear complex, nonlinear magnitude, linear complex, linear magnitude) a webMUSHRA listening test was performed. For the test, audio files which were encoded using the exemplary masked thresholds estimated by the different exemplary spreading functions were used. The quantization was adjusted to an average bitrate based on the perceptual entropy of, for example, 16 kBit/s. To achieve this, for each exemplary spreading function a scaling factor for the masked thresholds was calculated. For the exemplary spreading specific scaling factor, all different exemplary spreading kinds yield the same perceptual entropy for an input "all_mono" file. The scaling factors calculated this way were then used on the test items to achieve an average bitrate of, for example, 16 kBit/s for a large set of audio samples. All input test audios had a sample rate of, for example, 48 kHz and were encoded using a MDCT with a frame length of, for example, 1024 samples. The listening test consists of, for example, 8 test audios on which respectively all exemplary spreading functions were applied. For each audio, the listeners could listen to the original audio and the test audios for the different exemplary spreading functions and then rate the quality of the test audios on a scale of, for example, 0 to 100. Among the test audios always was the original audio to ensure reliable results. If a participant of the listening test rated an original audio below, for example, 90, that participant's results was excluded from the evaluation. The results shown in figure 19 contain listening tests from 7 subjects.
The listening test results (Fig. 20) clearly indicate that the test audios on which nonlinear spreading was performed have on average higher scores than, for example, the audios on which linear spreading was performed. This is visible in the "all items" section of the plot where the average test results for all audios are shown. The differences between the test audios are also very visible in the "pipe" audio. Here it appears again that the test audios with nonlinear spreading have a higher quality than the test audios with linear spreading. Also, in all items and the "pipe" audio there is no clear difference in the scores for complex and magnitude spreading for either nonlinear or linear spreading visible.

Summary of optional aspects regarding non-linear spreading

In this project, inter alia, 4 different kinds of frequency domain spreading were applied to the output of, for example, an All-pole gammatone filterbank. The resulting frequency spectrum was then used, for example, to estimate the masked threshold of the input sample which was then used, for example, to optimize the quantizer step size of the encoder. The implemented spreading functions are, for example, linear magnitude spreading, linear complex spreading, nonlinear magnitude spreading, and nonlinear complex spreading. The goal for the spreading was, for example, to match the frequency separation mechanism of the ear as closely as possible. Therefore, for example, the nonlinear spreading aimed to mimic the nonlinear properties of the human ear. The results of the performed listening test indicate that this was successful, as the test audios for which, for example, nonlinear spreading was used on average had a higher score than, for example, the audios on which linear spreading was used. While there appears to be no clear winner for the magnitude and complex spreading, the results show that frequency domain spreading with complex values works with the phase correction mechanism that was implemented in this project which has been disclosed above.

The new method presented herein comprises calculating masking thresholds for, for example, tonal and non-tonal signals, for example, without explicit tonality estimation. The tonality may be taken into account using a non linear spreading. Complex value IIR filter (e.g., an All-pole gammatone filterbank) with a smaller bandwidth compared to common gammatone filters may be used. Spreading with non-linearity may be applied to magnitudes or complex values with phase corrections. The choice of the phase correction is important. Compensating, respectively, the phase differences at the transition regions, at which the magnitude frequency responses of two adjacent filter are equal, has proven advantageous. Furthermore, one may bear in mind that with complex values, non linearity is applied, for example, only to the magnitudes such that the phases are not changed thereby. Such spreading may result in a significantly larger time resolution of the resulting superposition than the spreading with magnitudes. A special aspect of the method relates to a combination of complex value IIR filters (e.g., with smaller bandwidths compared to common gammatone filterbanks) and spreading with non linearity (onto magnitudes) and phase correction.

The present invention relates to the technical field of audio coding. For example, the present invention may be used in an audio encoder using current or future standards or proprietary coding methods. Hence, such an inventive audio encoder according to embodiments may, for example be configured to use current or future standards or proprietary coding methods.

The present invention relates to the technical field of psychoacoustic models with a gammatone filterbank and, e.g., non-linear spreading. The present invention may include processing complex values. The present invention may include phase correction. The present invention may comprise or be used in audio coding.

Example temporal/spectral magnitude responses

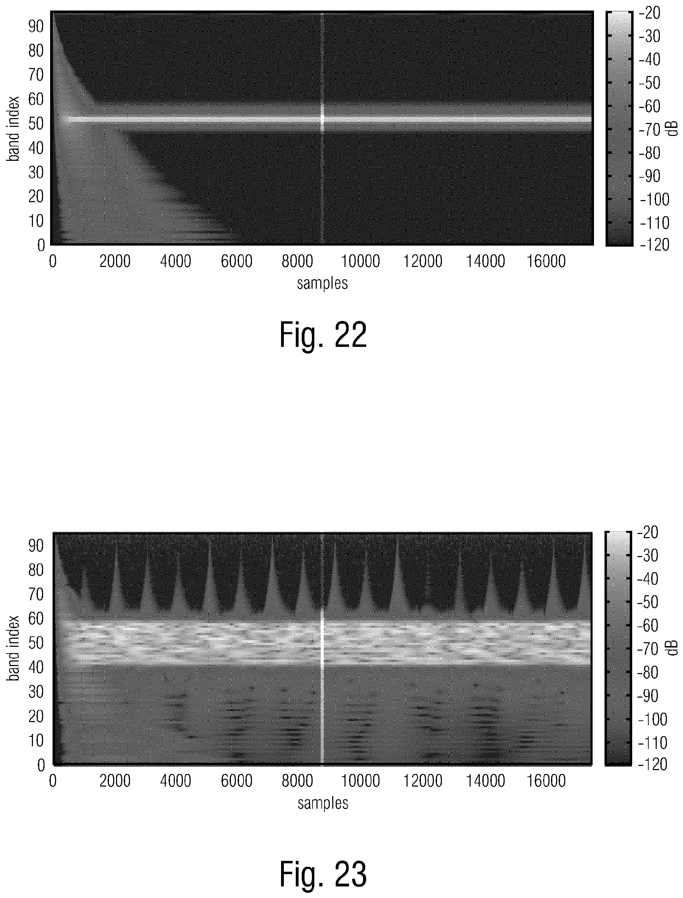

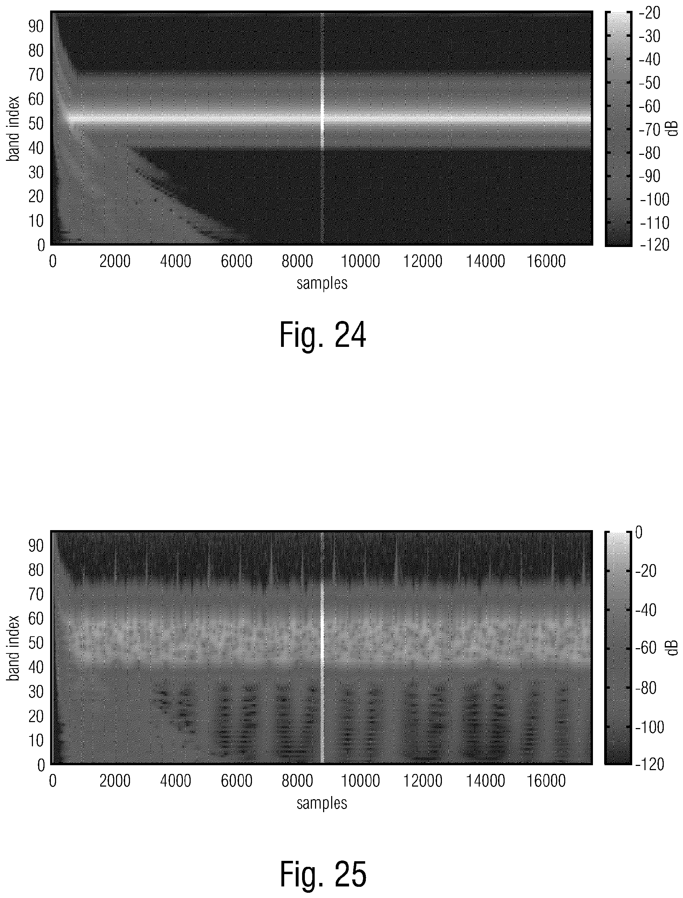

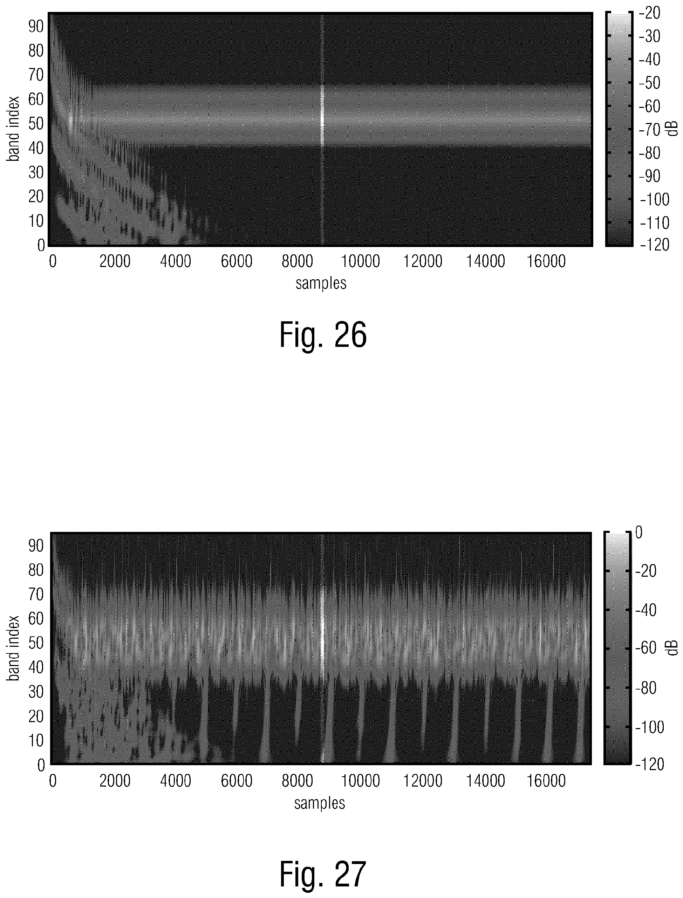

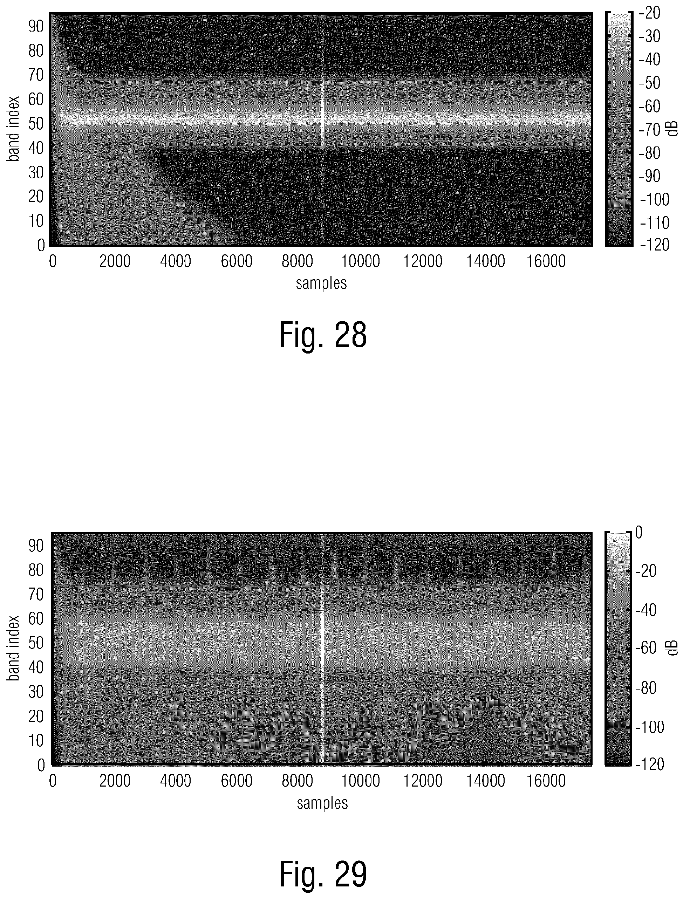

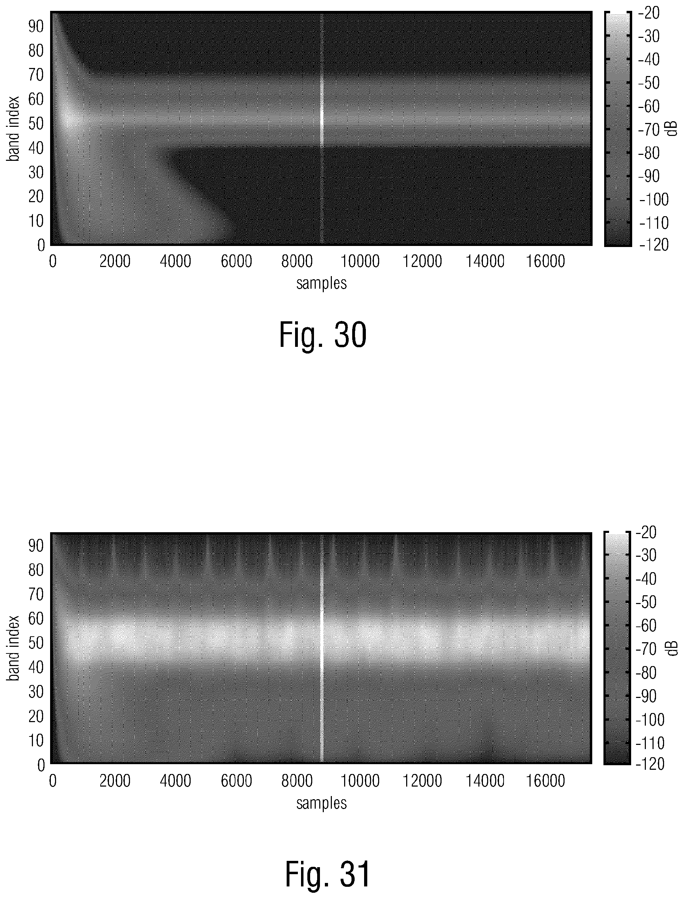

In the following further examples of magnitude responses, in the form of schematic spectrograms are shown in Fig. 22 to Fig. 31, according to embodiments: Fig. 22: Spectrogram sine with no spreading (example); Fig. 23: Spectrogram 3 bark noise with no spreading (example); Fig. 24: Spectrogram sine - complex linear spreading (example); Fig. 25: Spectrogram 3 bark noise - complex linear spreading (example); Fig. 26: Spectrogram sine - complex nonlinear spreading (example); Fig. 27: Spectrogram 3 bark noise - complex nonlinear spreading (example); Fig. 28: Spectrogram sine - magnitude linear spreading (example); Fig. 29: Spectrogram 3 bark noise - magnitude linear spreading (example); Fig. 30: Spectrogram sine - magnitude nonlinear spreading (example); Fig. 31: Spectrogram 3 bark noise - magnitude nonlinear spreading (example).

Optional aspects regarding subsampling and temporal averaging

Furthermore, in general, the masking threshold determinator can be configured to obtain the masking threshold information for each sample.

To reduce complexity, subsampling can, for example, be performed after the filterbank and before applying the non-linear mapping and spreading.

To obtain a masking threshold information for a given time interval, the (optionally subsampled) masking threshold information can optionally be averaged within this time interval.

This can be further improved by already performing the averaging of the masking threshold information in the non-linear domain.

Furthermore, additional processing (for considering, for example, postmasking) can, for example, be as well applied in the non-linear domain.

The mapping back to the linear domain in audio coding applications may, for example, just be required for the control of quantizer stepsizes.

This, e.g. the inventive, processing order can be motivated by the non-linear processing in the cochlea, which affects all following stages in the human auditory system.

Usual time intervals in audio encoders may, for example, correspond to the lengths of the MDCT windows, e.g. 2048 samples (long blocks) or 256 samples (short blocks).

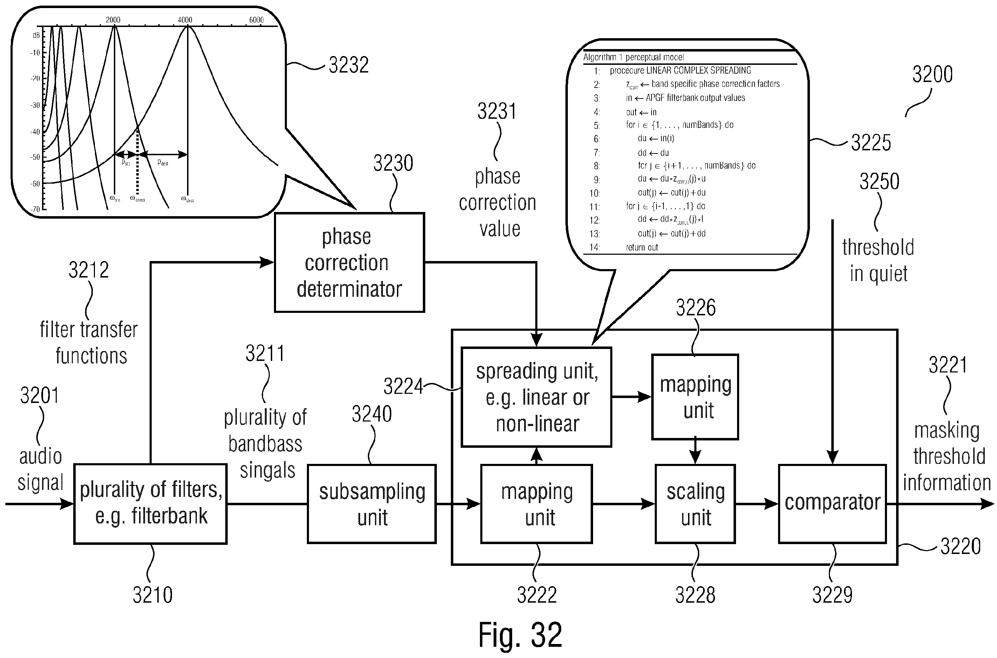

In the following, reference is made to Fig. 32. Fig. 32 shows a masking threshold determinator with a plurality of optional features, according to embodiments of the invention.

The masking threshold determinator of Fig. 32 may comprise any of the before discussed features and functionalities, individually or in combination. Fig. 32 shows masking threshold determinator 3200 comprising a plurality of filters 3210, e.g. in the form of a filterbank, for example any of the above discussed filterbanks, in particular an APGT-filterbank.

Furthermore, masking threshold determinator 3200 comprises a threshold analyzer 3220 and a phase correction determinator 3230. These elements may, for example, have the functionalities as explained in the context of Fig. 1 and 2. Furthermore, as an optional feature, masking threshold determinator 3200 comprises a subsampling unit 3240 and the threshold analyzer comprises an optional mapping unit 3222, an optional spreading unit 3224, e.g. having the features as discussed in the context of Fig. 12a and/or 12b, an optional mapping unit 1226, an optional scaling unit 3228 and an optional comparator 3229.

As shown, the plurality of filters 3210 are configured to receive an audio signal 3201. The filters may, for example, be ordered into different subsets, so that a filter subset comprises at least two of the plurality of filters 3210, and so that the filters of the filter subset jointly cover an equivalent rectangular bandwidth, ERB.

In particular, the filters may, for example, be implemented so as to cover respective frequency intervals of critical bands on a bark scale. In particular, center frequencies of the filters of the filterbank 3210 may be chosen, such that there are at least three filters per Bark, and/or such that the filters of the filterbank comprise 3dB bandwidths which are smaller than a third of a Bark. Referring to Fig. 5, a stimulation of different sections of the cochlea may hence be approximated efficiently, by the inventive implementation of the filter functions.

Examples for such filter function, e.g. transfer functions and impulse responses are shown in Fig. 7. In particular, the filters may optionally have asymmetric transfer function. Accordingly, as an example, the filterbank may be an All-Pole-Gammatone filterbank, for example configured to provide complex-valued bandpass signals.

As a general feature, optionally, the plurality of bandbass singals 3211, obtained by the filtering of audio signal 3201, may be complex valued.

For a given frequency region an attenuation of a filter of the filterbank 2110 at a frequency one Bark above and/or 1 Bark below its center frequency may, for example, be at least 40 dB.

As an optional feature, the plurality of bandpass signals 3211, e.g. at least two, may be subsampled using subsampling unit 3240. It is to be noted, that such a subsampling is optional. To reduce complexity, such a subsampling can be performed after the filterbank 3240, and before further processing, for example comprising applying a non-linear mapping and spreading.

Using phase correction determinator 3230, the masking threshold determinator 3200 is configured to determine a phase correction value 3231 based on or using phases of the bandpass signal values. In particular, threshold analyzer 3220 is configured to apply the phase correction value 3231 to at least one of the at least two bandpass signals in order to obtain the masking threshold information 3221.

As explained before, the phase correction value 3231 may, for example, describe a phase difference between transfer functions of filters having adjacent passbands at a transition frequency, e.g. $\omega_{cross}$. As shown in the excerpt 3232 from Fig. 11, phase correction determinator 3230 may be configured to determine the phase correction value 3231 based on a transition frequency between a first passband of a first filter (e.g. src) and an adjacent second passband of a second filter (e.g. dest), so that a phase correction 3231 value between the first filter and the second filter is a combination a first phase shift between a pole of the first passband and the crossing frequency and of a second phase shift between a pole of the second passband and the crossing frequency.

Accordingly, a plurality of phase correction values for the different filters of the plurality of filters 3210 may, for example, be determined. For a filter of the plurality of filters 3210, a first phase correction value may, for example, be assigned relative to an adjacent filter with a smaller band index and a second phase correction value may be assigned relative to an adjacent filter with a larger band index.

As an example, a phase correction value $z_{corr}$ between a source band and a destination band may be determined according to equation 6, e.g. as explained in the context of Fig. 11. For the evaluation of equation 6, optionally $p_{src}$ and $p_{dest}$ may be determined according to

$$p_{src} = \varphi_{src}(\omega_{cross}) + \omega_{cross} * d_{src}$$

and

$$p_{dest} = \varphi_{dest}(\omega_{cross}) + \omega_{cross} * d_{dest}$$

and/or, for example for an all-pole gammatone filter, according to

$$p_{src} = O * \left(\omega_c - \arg\left(e^{j\omega_{cross}} - z_{\infty,src}\right)\right) + \omega_{cross} * d_{src}$$

and

$$p_{dest} = O * \left(\omega_c - \arg\left(e^{j\omega_{cross}} - z_{\infty,dest}\right)\right) + \omega_{cross} * d_{dest}.$$

For the sake of brevity, for the definition of the respective further parameters and variables, reference is made to the above discussion, in particular of Fig. 10 and 11.

As shown in Fig. 32, the threshold analyzer 3200 may be provided with one or more phase correction values 3231 and a plurality of, optionally subsampled, bandpass signals 3211 (e.g. at least two).

As an optional feature, using mapping unit 3222, analyzer 3220 may be configured to apply a non-linear mapping to respective magnitudes of complex values of the bandpass signal 3211, while keeping respective phase values of the complex values unchanged, except for an optional phase correction, e.g. as performed in spreading unit 3224 based on the phase correction value(s) 3231.

In other words, the input values of analyzer 3220 may optionally be mapped or transformed in a non-linear domain, for the further processing in spreading unit 3224.

Furthermore, using spreading unit 3224, after frequency decomposition in filterbank 3210, spreading functions may be applied to the frequency spectrum to model the frequency separation mechanism of the human inner ear. The spreading unit 3224 may be configured to perform linear magnitude spreading, linear complex spreading, nonlinear magnitude spreading and/or nonlinear complex spreading. It is to be noted that a respective linear spreading may be performed without any mapping to a non-linear domain and hence without a mapping unit 3222 (accordingly units 3226 and 3228 may, for example, not be present either).

In general, spreading unit 3224 may be configured to combine bandpass signal values of different bandpass signals 3211 in order to obtain the masking threshold information 3221. Therefore, for a given frequency region, a weighted combination of bandpass signal values, or non-linearly processed versions of the bandpass signal values, associated with a plurality of frequency regions, may be used. An example for an algorithm for the linear case is shown in the excerpt 3225 from Fig. 13. Weighting may be performed based on spreading factors u and l, in order to obtain a weighted combination. As shown, optionally, the weighting may comprises the phase correction ($z_{corr}$). In particular, the weighted combination may be determined using equation 7, for example in the linear case and/or according to

$$y_{nl,b} = x_{nl,b} + \sum_{k=0}^{b-1} x_{nl,k} u_{nl,k,b} + \sum_{k=b+1}^{B-1} x_{nl,k} l_{nl,k,b} \qquad \forall b, 0 \le b \le B - 1$$

in the non-linear case.

Optionally, the weighting may decrease with increasing difference between a center frequency (e.g. center frequency) of the given frequency region and center frequencies of one or more other frequency regions. In particular, the weighting may reduce exponentially with increasing difference between a frequency band index of the given frequency band and a frequency band index of another frequency band. Furthermore, bandpass signal values or non-linearly processed versions of the bandpass signal values of frequency regions below the given frequency region may, for example, be weighted differently than bandpass signal values or non-linearly processed versions of the bandpass signal values of frequency regions above the given frequency region.

Optionally, at least one of the upper spreading factor, e.g. $u_{nl,k,b}$, and the lower spreading factor, e.g. $l_{nl,k,b}$, may, for example, be dependent on a difference between the running variable k and the band index b. As another optional feature, at least one of the upper spreading factor, e.g. $u_{nl,k,b}$, and the lower spreading factor, e.g. $l_{nl,k,b}$, may, for example, reduce exponentially with increasing difference between the running variable k and the band index b. Hence, based on such a difference between the running variable k and the band index b, the spreading unit 3224 may be configured to determine a spreading output, using the equation

$$y_{nl,b} = x_{nl,b} + \sum_{k=0}^{b-1} x_{nl,k} u^{\alpha(b-k)} + \sum_{k=b+1}^{B-1} x_{nl,k} l^{\alpha(k-b)} \quad \forall b, 0 \leq b \leq B-1.$$

As another optional feature, a spreading output of spreading unit 3224, may be mapped back, in the non-linear case, to a linear domain, using mapping unit 3226. This mapping can optionally be performed after the averaging of the masking threshold in the non-linear domain. Optionally, the spreading output in linear domain may be scaled, e.g. scaled down, using scaling unit 3228 in order to obtain a masking threshold representing masking effects of audio signal 3201.

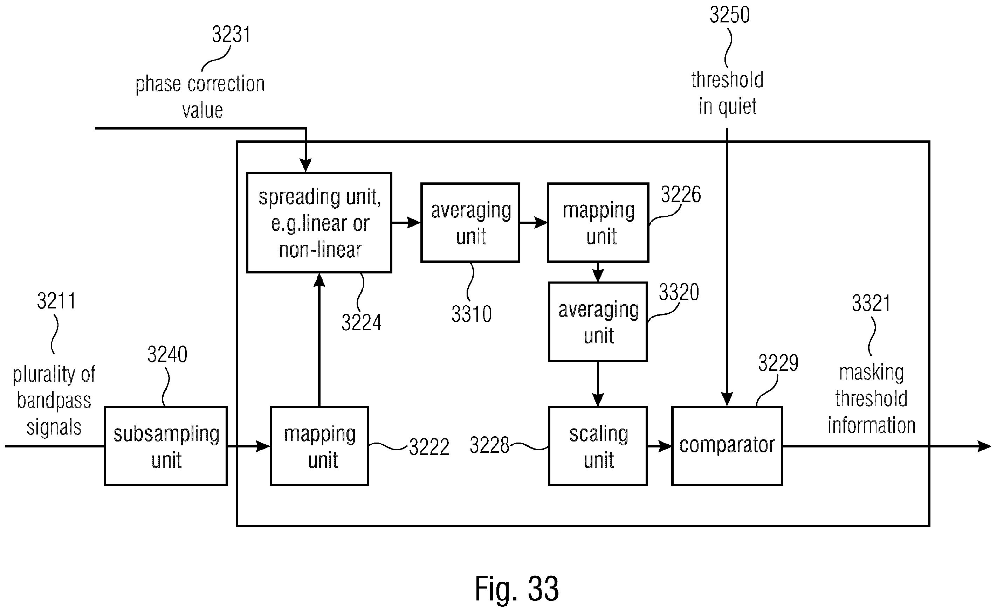

Here, reference is made to Fig. 33. Fig. 33 shows a schematic view of an optional configuration of the threshold analyzer 3220 of Fig. 32 (in the form of threshold analyzer 3320), according to an embodiment of the invention. In contrast to threshold analyzer 3320 of Fig. 32, optional averaging units 3310 and 3320 are explicitly shown. It is to be noted that both averaging units are shown here for illustrative purposes, however, only one of the two units 3310 and 3320 may be present in an inventive threshold analyzer.

As an example, the averaging of the masking threshold information may hence be performed in a non-linear domain, for example, using an averaging unit 3310 or in the linear domain using averaging unit 3320. Hence, as shown in Fig. 33 a respective masking threshold information 3321, based on any of the above averagings, may be provided.

As an example, using the scaling unit 3228, the masking threshold information may be obtained using, in case of $x_{nl}$ being defined as $x_{nl}=|x|^{\alpha}$, the equation

$$|y| = s_{nl,mag} * |y_{nl}|^{\frac{1}{\alpha}}$$

with a scaling factor $s_{nl,mag}$ for non-linear magnitude spreading and the spreading output $y_{nl}$, or, in case of $x_{nl}$ being defined as $x_{nl}=x*|x|^{\alpha-1}$, the equation

$$|y| = s_{nl,c} * y_{nl} * |y_{nl}|^{\frac{1}{\alpha-1}}$$

with a scaling factor $s_{nl,mag}$ for non-linear complex spreading and the spreading output $y_{nl}$.

Furthermore, using the optional comparator 3229, a masking threshold obtained using the spreading unit 3224 may be compared to a threshold in quiet 3250 (e.g. referred to as masking threshold in quiet 3250), in order to select a bigger one of the two as the masking threshold information 3221.

It should be noted that individual aspects described herein can be used individually or in combination. Thus, details can be added to each of said individual aspects without adding details to another one of said aspects.

It should also be noted that the present disclosure describes, explicitly or implicitly, features usable in an audio encoder (Encoder for providing an encoded representation of audio signals) and in an audio decoder (Decoder for providing decoded audio signals on the basis of an encoded representation). Thus, any of the features described herein can be used in the context of an audio encoder and in the context of an audio decoder.

Moreover, features and functionalities disclosed herein relating to a method can also be used in an apparatus (configured to perform such functionality). Furthermore, any features and functionalities disclosed herein with respect to an apparatus can also be used in a corresponding method. In other words, the methods disclosed herein can optionally be supplemented by any of the features and functionalities described with respect to the apparatuses.

Also, any of the features and functionalities described herein can be implemented in hardware or in software, or using a combination of hardware and software, as will be described in the section "implementation alternatives".

Implementation alternatives:

Although some aspects are described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the invention can be implemented in hardware or in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the inventive methods described herein is performed.

Generally, embodiments of the present invention can be implemented as a computer program product with a program code, the program code being operative for performing one of the inventive methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the inventive methods described herein, when the computer program runs on a computer.

A further embodiment of the inventive methods is, therefore, a data carrier (or a digital storage medium, or a computer-readable medium) comprising, recorded thereon, the computer program for performing one of the inventive methods described herein. The data carrier, the digital storage medium or the recorded medium are typically tangible and/or non-transitionary.

A further embodiment of the inventive method is, therefore, a data stream or a sequence of signals representing the computer program for performing one of the inventive methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the inventive methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The apparatus described herein, or any components of the apparatus described herein, may be implemented at least partially in hardware and/or in software.

The methods described herein may be performed using a hardware apparatus, or using a computer, or using a combination of a hardware apparatus and a computer.

The methods described herein, or any components of the apparatus described herein, may be performed at least partially by hardware and/or by software.

The described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

**References**

[1] Lars Chittka and Axel Brockmann. Perception space-the final frontier. PLoS biology, 3(4):e137, 2005.

[2] Hugo Fastl and Eberhard Zwicker. Psychoacoustics: facts and models, volume 22. Springer Science & Business Media, 2006.

[3] Brian CJ Moore. An introduction to the psychology of hearing. Brill, 2012.

[4] Richard F Lyon. The all-pole gammatone filter and auditory models. In Acustica. Citeseer, 1996.

[5] Richard F Lyon, Andreas G Katsiamis, and Emmanuel M Drakakis. History and future of auditory filter models. In Proceedings of 2010 IEEE International Symposium on Circuits and Systems, pages 3809-3812. IEEE, 2010.

[6] Frank Baumgarte, Charalampos Ferekidis, and Hendrik Fuchs. A nonlinear psychoacoustic model applied to the iso mpeg layer 3 coder, 99th aes convention. New York (Oct. 1995).

[7] ITUR Recommendation. Methods for objective measurements of perceived audio quality. ITU-R BS, 13871, 2001.

**Claims**

1. A masking threshold determinator (100, 200, 340, 1200, 1300, 3200),

   wherein the masking threshold determinator is configured to obtain a plurality of bandpass signals (111, 211, 311, 1211, 1311, 3211) using a plurality of filters (110, 210, 310, 1210, 1310, 3210) having different bandwidths; and
   wherein the masking threshold determinator is configured to obtain a masking threshold information (121, 221, 321, 341, 1221, 1244, 1321, 1341, 1520-1550, 1820-1850, 1920-1950, 2020, 3221, 3321) associated with a given frequency region on the basis of bandpass signal values of at least two bandpass signals (111, 211, 311, 1211, 1311, 3211);
   wherein the bandpass signal values are complex values;
   wherein the masking threshold determinator is configured to take phases of the bandpass signal values into account when obtaining the masking threshold information (121, 221, 321, 341, 1221, 1244, 1321, 1341, 1520-1550, 1820-1850, 1920-1950, 2020, 3221, 3321) associated with the given frequency region on the basis of bandpass signal values of the at least two bandpass signals (111, 211, 311, 1211, 1311, 3211);
   wherein the masking threshold determinator is configured to apply a phase correction value (231, 3231) to at least one of the at least two bandpass signals (111, 211, 311, 1211, 1311, 3211) when obtaining the masking threshold information (121, 221, 321, 341, 1221, 1244, 1321, 1341, 1520-1550, 1820-1850, 1920-1950, 2020, 3221, 3321).

2. The masking threshold determinator (100, 200, 340, 1200, 1300, 3200) according to claim 1,
   wherein the phase correction value (231, 3231) describes a phase difference between transfer functions of filters (110, 210, 310, 1210, 1310, 3210) having adjacent passbands at a transition frequency.

3. The masking threshold determinator (100, 200, 340, 1200, 1300, 3200) according to claim 1 or 2,

   wherein between a first passband of a first filter and an adjacent second passband of a second filter there is a transition frequency,
   wherein a phase correction value (231, 3231) between the first filter and the second filter is a combination a first phase shift (1032) between a pole of the first passband and the crossing frequency and of a second phase shift (1034) between a pole of the second passband and the crossing frequency.

4. The masking threshold determinator (100, 200, 340, 1200, 1300, 3200) according to claim 2 or 3,
   wherein the first filter is assigned a first phase correction value relative to an adjacent filter with a smaller band index and a second phase correction value relative to an adjacent filter with a larger band index.

5. The masking threshold determinator (100, 200, 340, 1200, 1300, 3200) according to any of claims 1 to 4,
   wherein the masking threshold determinator is configured to a apply a non-linear mapping (1352, 3222) to respective magnitudes of complex values of the bandpass signal (111, 211, 311, 1211, 1311, 3211) while keeping respective phase values of the complex values unchanged except for an optional phase correction (231, 3231).

6. The masking threshold determinator (100, 200, 340, 1200, 1300, 3200) according to any of the claims 1 to 5,
   wherein the masking threshold determinator (100, 200, 340, 1200, 1300, 3200) is configured to obtain a masking threshold information (121, 221, 321, 341, 1221, 1244, 1321, 1341, 1520-1550, 1820-1850, 1920-1950, 2020, 3221, 3321) associated with a given frequency region on the basis of magnitudes of the bandpass signal values of the at least two bandpass signals (111, 211, 311, 1211, 1311, 3211).

7. The masking threshold determinator (100, 200, 340, 1200, 1300, 3200) according to any of the preceding claims,

   wherein center frequencies of the filters (110, 210, 310, 1210, 1310, 3210) of the filterbank are chosen such that there are at least three filters per Bark, and/or
   wherein the filters of the filterbank comprise 3dB bandwidths which are smaller than a third of a Bark.

8. The masking threshold determinator (100, 200, 340, 1200, 1300, 3200) according to any of the preceding claims,

   wherein the filters (110, 210, 310, 1210, 1310, 3210) of the filterbank are chosen to have an asymmetric transfer function, and/or
   wherein the filterbank is an All-Pole-Gammatone filterbank, and/or
   wherein the filterbank is a complex-valued All-Pole-Gammatone filterbank.

9. The masking thresholding determinator (100, 200, 340, 1200, 1300, 3200) according to any of the preceding claims, wherein for the given frequency region, an attenuation of a filter of the filterbank at a frequency one Bark above and/or 1 Bark below its center frequency is at least 40 dB.

10. The masking threshold determinator (100, 200, 340, 1200, 1300, 3200) according to any of the preceding claims, wherein the masking threshold determinator is configured to perform an additional processing, e.g. for considering postmasking, in a non-linear domain.

11. The masking threshold determinator (100, 200, 340, 1200, 1300, 3200) according to claim 10,

wherein the masking threshold determinator is configured to a apply a non-linear mapping (1352, 3222) to respective magnitudes of complex values of the bandpass signal while keeping respective phase values of the complex values unchanged except for an optional phase correction (231, 3231); and
wherein the masking threshold determinator is configured to perform an additional processing of the non-linearly mapped magnitudes of the bandpass signal in order to consider postmasking.

12. An audio encoder for encoding an input audio signal,

comprising the masking threshold determinator (100, 200, 340, 1200, 1300, 3200) according to any of the preceding claims;
wherein the audio encoder is configured to adjust a quantization step for quantizing the input audio signal, or a preprocessed version thereof, in dependence on the masking threshold.

13. The audio encoder according to claim 12, configured to

determine for the given frequency region a larger value of the obtained masking threshold information (121, 221, 321, 341, 1221, 1244, 1321, 1341, 1520-1550, 1820-1850, 1920-1950, 2020, 3221, 3321) and a pre-determined threshold in quiet (324, 3250), and
select a quantizer step size for the given frequency region based determined larger value, and, optionally, encode an audio signal using the selected quantizer step size.

14. A method for determining masking threshold information (121, 221, 321, 341, 1221, 1244, 1321, 1341, 1520-1550, 1820-1850, 1920-1950, 2020, 3221, 3321), comprising

obtaining a plurality of bandpass signals (111, 211, 311, 1211, 1311, 3211) using a plurality of filters (110, 210, 310, 1210, 1310, 3210) having different bandwidths, and obtain the masking threshold information associated with a given frequency region on the basis of bandpass signal values of at least two bandpass signals (111, 211, 311, 1211, 1311, 3211);
wherein the bandpass signal values are complex values;
wherein the method comprises taking phases of the bandpass signal values into account when obtaining the masking threshold information (121, 221, 321, 341, 1221, 1244, 1321, 1341, 1520-1550, 1820-1850, 1920-1950, 2020, 3221, 3321) associated with the given frequency region on the basis of bandpass signal values of the at least two bandpass signals (111, 211, 311, 1211, 1311, 3211);
wherein the method comprises applying a phase correction value (231, 3231) to at least one of the at least two bandpass signals (111, 211, 311, 1211, 1311, 3211) when obtaining the masking threshold information (121, 221, 321, 341, 1221, 1244, 1321, 1341, 1520-1550, 1820-1850, 1920-1950, 2020, 3221, 3321).

15. A computer program for performing the method according to claim 14 when the computer program runs on a computer.

**Patentansprüche**

1. Eine Maskierungsschwellenbestimmungsvorrichtung (100, 200, 340, 1200, 1300, 3200),

wobei die Maskierungsschwellenbestimmungsvorrichtung dazu konfiguriert ist, eine Mehrzahl von Bandpasssignalen (111, 211, 311, 1211, 1311, 3211) unter Verwendung einer Mehrzahl von Filtern (110, 210, 310, 1210, 1310, 3210) mit unterschiedlichen Bandbreiten zu erhalten; und
wobei die Maskierungsschwellenbestimmungsvorrichtung dazu konfiguriert ist, eine Maskierungsschwelleninformation (121, 221, 321, 341, 1221, 1244, 1321, 1341, 1520-1550, 1820-1850, 1920-1950, 2020, 3221, 3321) zu erhalten, die einer vorgegebenen Frequenzregion zugeordnet ist, basierend auf Bandpasssignalwerten von zumindest zwei Bandpasssignalen (111, 211, 311, 1211, 1311, 3211);

wobei die Bandpasssignalwerte komplexe Werte sind;

wobei die Maskierungsschwellenbestimmungsvorrichtung dazu konfiguriert ist, beim Erhalten der Maskierungsschwelleninformation (121, 221, 321, 341, 1221, 1244, 1321, 1341, 1520-1550, 1820-1850, 1920-1950, 2020, 3221, 3321), die der vorgegebenen Frequenzregion zugeordnet ist, basierend auf Bandpasssignalwerten der zumindest zwei Bandpasssignale (111, 211, 311, 1211, 1311, 3211) Phasen der Bandpasssignalwerte zu berücksichtigen;

wobei die Maskierungsschwellenbestimmungsvorrichtung dazu konfiguriert ist, beim Erhalten der Maskierungsschwelleninformation (121, 221, 321, 341, 1221, 1244, 1321, 1341, 1520-1550, 1820-1850, 1920-1950, 2020, 3221, 3321) einen Phasenkorrekturwert (231, 3231) auf zumindest eins der zumindest zwei Bandpasssignale (111, 211, 311, 1211, 1311, 3211) anzuwenden.

2.  Die Maskierungsschwellenbestimmungsvorrichtung (100, 200, 340, 1200, 1300, 3200) gemäß Anspruch 1, wobei der Phasenkorrekturwert (231, 3231) eine Phasendifferenz zwischen Übertragungsfunktionen von Filtern (110, 210, 310, 1210, 1310, 3210) mit angrenzenden Durchlassbändern bei einer Übergangsfrequenz beschreibt.

3.  Die Maskierungsschwellenbestimmungsvorrichtung (100, 200, 340, 1200, 1300, 3200) gemäß Anspruch 1 oder 2,

wobei zwischen einem ersten Durchlassband eines ersten Filters und einem angrenzenden zweiten Durchlassband eines zweiten Filters eine Übergangsfrequenz besteht,
wobei ein Phasenkorrekturwert (231, 3231) zwischen dem ersten Filter und dem zweiten Filter eine Kombination aus einer ersten Phasenverschiebung (1032) zwischen einem Pol des ersten Durchlassbands und der Kreuzungsfrequenz und aus einer zweiten Phasenverschiebung (1034) zwischen einem Pol des zweiten Durchlassbands und der Kreuzungsfrequenz.

4.  Die Maskierungsschwellenbestimmungsvorrichtung (100, 200, 340, 1200, 1300, 3200) gemäß Anspruch 2 oder 3, wobei dem ersten Filter ein erster Phasenkorrekturwert in Bezug auf ein angrenzendes Filter mit einem kleineren Bandindex und ein zweiter Phasenkorrekturwert in Bezug auf ein angrenzendes Filter mit einem größeren Bandindex zugewiesen ist.

5.  Die Maskierungsschwellenbestimmungsvorrichtung (100, 200, 340, 1200, 1300, 3200) gemäß einem der Ansprüche 1 bis 4, wobei die Maskierungsschwellenbestimmungsvorrichtung dazu konfiguriert ist, eine nicht lineare Abbildung (1352, 3222) auf jeweilige Größen komplexer Werte des Bandpasssignals (111, 211, 311, 1211, 1311, 3211) anzuwenden und gleichzeitig jeweilige Phasenwerte der komplexen Werte unverändert beizubehalten, abgesehen von einer optionalen Phasenkorrektur (231, 3231).

6.  Die Maskierungsschwellenbestimmungsvorrichtung (100, 200, 340, 1200, 1300, 3200) gemäß einem der Ansprüche 1 bis 5, wobei die Maskierungsschwellenbestimmungsvorrichtung (100, 200, 340, 1200, 1300, 3200) dazu konfiguriert ist, eine Maskierungsschwelleninformation (121, 221, 321, 341, 1221, 1244, 1321, 1341, 1520-1550, 1820-1850, 1920-1950, 2020, 3221, 3321) zu erhalten, die einer vorgegebenen Frequenzregion zugeordnet ist, basierend auf Größen der Bandpasssignalwerte der zumindest zwei Bandpasssignale (111, 211, 311, 1211, 1311, 3211).

7.  Die Maskierungsschwellenbestimmungsvorrichtung (100, 200, 340, 1200, 1300, 3200) gemäß einem der vorhergehenden Ansprüche,

wobei Mittenfrequenzen der Filter (110, 210, 310, 1210, 1310, 3210) der Filterbank derart ausgewählt sind, dass zumindest drei Filter pro Bark vorliegen, und/oder
wobei die Filter der Filterbank Bandbreiten von 3 dB aufweisen, die kleiner als ein Drittel eines Bark sind.

8.  Die Maskierungsschwellenbestimmungsvorrichtung (100, 200, 340, 1200, 1300, 3200) gemäß einem der vorhergehenden Ansprüche,

wobei die Filter (110, 210, 310, 1210, 1310, 3210) der Filterbank dahingehend ausgewählt sind, eine asymmetrische Übertragungsfunktion aufzuweisen, und/oder

wobei die Filterbank eine All-Pole-Gammatone-Filterbank ist, und/oder
wobei die Filterbank eine komplexwertige All-Pole-Gammatone-Filterbank ist.

9.  Die Maskierungsschwellenbestimmungsvorrichtung (100, 200, 340, 1200, 1300, 3200) gemäß einem der vorhergehenden Ansprüche,
wobei für die vorgegebene Frequenzregion eine Dämpfung eines Filters der Filterbank bei einer Frequenz von einem Bark über und/oder einem Bark unter der Mittenfrequenz desselben zumindest 40 dB beträgt.

10. Die Maskierungsschwellenbestimmungsvorrichtung (100, 200, 340, 1200, 1300, 3200) gemäß einem der vorhergehenden Ansprüche,
wobei die Maskierungsschwellenbestimmungsvorrichtung dazu konfiguriert ist, eine zusätzliche Verarbeitung, beispielsweise zum Berücksichtigen einer Nachmaskierung, in einem nicht linearen Bereich durchzuführen.

11. Die Maskierungsschwellenbestimmungsvorrichtung (100, 200, 340, 1200, 1300, 3200) gemäß Anspruch 10,

wobei die Maskierungsschwellenbestimmungsvorrichtung dazu konfiguriert ist, eine nicht lineare Abbildung (1352, 3222) auf jeweilige Größen komplexer Werte des Bandpasssignals anzuwenden und gleichzeitig jeweilige Phasenwerte der komplexen Werte unverändert beizubehalten, abgesehen von einer optionalen Phasenkorrektur (231, 3231); und
wobei die Maskierungsschwellenvorrichtung dazu konfiguriert ist, eine zusätzliche Verarbeitung der nicht linear gemappten Größen des Bandpasssignals durchzuführen, um eine Nachmaskierung zu berücksichtigen.

12. Ein Audiocodierer zum Codieren eines Eingangsaudiosignals,

der die Maskierungsschwellenbestimmungsvorrichtung (100, 200, 340, 1200, 1300, 3200) gemäß einem der vorhergehenden Ansprüche aufweist;
wobei der Audiocodierer dazu konfiguriert ist, einen Quantisierungsschritt zum Quantisieren des Eingangsaudiosignals oder einer vorbearbeiteten Version desselben in Abhängigkeit von der Maskierungsschwelle anzupassen.

13. Der Audiodecodierer gemäß Anspruch 12, der konfiguriert ist zum

Bestimmen, für die vorgegebene Frequenzregion, eines größeren Werts der erhaltenen Maskierungsschwelleninformation (121, 221, 321, 341, 1221, 1244, 1321, 1341, 1520-1550, 1820-1850, 1920-1950, 2020, 3221, 3321) und einer vorbestimmten Schwelle bei Stille (324, 3250), und
Auswählen einer Quantisierungsschrittgröße für die vorgegebene Frequenzregion basierend auf einem bestimmten größeren Wert und, optional,
Codieren eines Audiosignals unter Verwendung der ausgewählten Quantisierungsschrittgröße

14. Ein Verfahren zum Bestimmen einer Maskierungsschwelleninformation (121, 221, 321, 341, 1221, 1244, 1321, 1341, 1520-1550, 1820-1850, 1920-1950, 2020, 3221, 3321), wobei das Verfahren folgende Schritte aufweist:

Erhalten einer Mehrzahl von Bandpasssignalen (111, 211, 311, 1211, 1311, 3211) unter Verwendung einer Mehrzahl von Filtern (110, 210, 310, 1210, 1310, 3210) mit unterschiedlichen Bandbreiten, und
Erhalten der Maskierungsschwelleninformation, die einer vorgegebenen Frequenzregion zugeordnet ist, basierend auf Bandpasssignalwerten von zumindest zwei Bandpasssignalen (111, 211, 311, 1211, 1311, 3211);
wobei die Bandpasssignalwerte komplexe Werte sind;
wobei das Verfahren beim Erhalten der Maskierungsschwelleninformation (121, 221, 321, 341, 1221, 1244, 1321, 1341, 1520-1550, 1820-1850, 1920-1950, 2020, 3221, 3321), die der vorgegebenen Frequenzregion zugeordnet ist, basierend auf Bandpasssignalwerten der zumindest zwei Bandpasssignale (111, 211, 311, 1211, 1311, 3211) ein Berücksichtigen von Phasen der Bandpasssignalwerte aufweist;
wobei das Verfahren beim Erhalten der Maskierungsschwelleninformation (121, 221, 321, 341, 1221, 1244, 1321, 1341, 1520-1550, 1820-1850, 1920-1950, 2020, 3221, 3321) ein Anwenden eines Phasenkorrekturwerts (231, 3231) auf zumindest eins der zumindest zwei Bandpasssignale (111, 211, 311, 1211, 1311, 3211) aufweist.

15. Ein Computerprogramm zum Durchführen des Verfahrens gemäß Anspruch 14, wenn das Computerprogramm auf einem Computer läuft.

**Revendications**

1. Déterminateur de seuil de masquage (100, 200, 340, 1200, 1300, 3200),

   dans lequel le déterminateur de seuil de masquage est configuré pour obtenir une pluralité de signaux passe-bande (111, 211, 311, 1211, 1311, 3211) en utilisant une pluralité de filtres (110, 210, 310, 1210, 1310, 3210) ayant différentes largeurs de bande ; et
   dans lequel le déterminateur de seuil de masquage est configuré pour obtenir des informations de seuil de masquage (121, 221, 321, 341, 1221, 1244, 1321, 1341, 1520-1550, 1820-1850, 1920-1950, 2020, 3221, 3321) associées à une région de fréquence donnée sur la base des valeurs de signal passe-bande d'au moins deux signaux passe-bande (111, 211, 311, 1211, 1311, 3211) ;
   dans lequel les valeurs de signal passe-bande sont des valeurs complexes ;
   dans lequel le déterminateur de seuil de masquage est configuré pour prendre en compte les phases des valeurs de signal passe-bande lors de l'obtention des informations de seuil de masquage (121, 221, 321, 341, 1221, 1244, 1321, 1341, 1520-1550, 1820-1850, 1920-1950, 2020, 3221, 3321) associées à la région de fréquence donnée sur la base des valeurs de signal passe-bande de l'au moins deux signaux passe-bande (111, 211, 311, 1211, 1311, 3211) ;
   dans lequel le déterminateur de seuil de masquage est configuré pour appliquer une valeur de correction de phase (231, 3231) à au moins l'un des au moins deux signaux passe-bande (111, 211, 311, 1211, 1311, 3211) lors de l'obtention des informations de seuil de masquage (121, 221, 321, 341, 1221, 1244, 1321, 1341, 1520-1550, 1820-1850, 1920-1950, 2020, 3221, 3321).

2. Déterminateur de seuil de masquage (100, 200, 340, 1200, 1300, 3200) selon la revendication 1,
   dans lequel la valeur de correction de phase (231, 3231) décrit une différence de phase entre les fonctions de transfert des filtres (110, 210, 310, 1210, 1310, 3210) ayant des bandes passantes adjacentes à une fréquence de transition.

3. Déterminateur de seuil de masquage (100, 200, 340, 1200, 1300, 3200) selon la revendication 1 ou 2,

   dans lequel, entre une première bande passante d'un premier filtre et une deuxième bande passante adjacente d'un deuxième filtre, il existe une fréquence de transition,
   dans lequel une valeur de correction de phase (231, 3231) entre le premier filtre et le deuxième filtre est une combinaison d'un premier déphasage (1032) entre un pôle de la première bande passante et la fréquence de coupure et d'un deuxième déphasage (1034) entre un pôle de la deuxième bande passante et la fréquence de coupure.

4. Déterminateur de seuil de masquage (100, 200, 340, 1200, 1300, 3200) selon la revendication 2 ou 3,
   dans lequel le premier filtre se voit attribuer une première valeur de correction de phase par rapport à un filtre adjacent ayant un indice de bande plus petit et une deuxième valeur de correction de phase par rapport à un filtre adjacent ayant un indice de bande plus grand.

5. Déterminateur de seuil de masquage (100, 200, 340, 1200, 1300, 3200) selon l'une quelconque des revendications 1 à 4,
   dans lequel le déterminateur de seuil de masquage est configuré pour appliquer un mappage non linéaire (1352, 3222) aux grandeurs respectives des valeurs complexes du signal passe-bande (111, 211, 311, 1211, 1311, 3211) tout en conservant inchangées les valeurs de phase respectives des valeurs complexes, à l'exception d'une correction de phase facultative (231, 3231).

6. Déterminateur de seuil de masquage (100, 200, 340, 1200, 1300, 3200) selon l'une quelconque des revendications 1 à 5,
   dans lequel le déterminateur de seuil de masquage (100, 200, 340, 1200, 1300, 3200) est configuré pour obtenir des informations de seuil de masquage (121, 221, 321, 341, 1221, 1244, 1321, 1341, 1520-1550, 1820-1850, 1920-1950, 2020, 3221, 3321) associées à une région de fréquence donnée sur la base des grandeurs des valeurs de signal passe-bande de l'au moins deux signaux passe-bande (111, 211, 311, 1211, 1311, 3211).

7. Déterminateur de seuil de masquage (100, 200, 340, 1200, 1300, 3200) selon l'une quelconque des revendications précédentes,

   dans lequel les fréquences centrales des filtres (110, 210, 310, 1210, 1310, 3210) du banc de filtres sont choisies de sorte qu'il y ait au moins trois filtres par Bark, et/ou

dans lequel les filtres du banc de filtres comprennent des largeurs de bande de 3 dB qui sont inférieures à un tiers d'un Bark.

8. Déterminateur de seuil de masquage (100, 200, 340, 1200, 1300, 3200) selon l'une quelconque des revendications précédentes,

dans lequel les filtres (110, 210, 310, 1210, 1310, 3210) du banc de filtres sont choisis pour avoir une fonction de transfert asymétrique, et/ou
dans lequel le banc de filtres est un banc de filtres All-Pole-Gammatone, et/ou
dans lequel le banc de filtres est un banc de filtres All-Pole-Gammatone à valeurs complexes.

9. Déterminateur de seuil de masquage (100, 200, 340, 1200, 1300, 3200) selon l'une quelconque des revendications précédentes,
dans lequel, pour la région de fréquence donnée, une atténuation d'un filtre du banc de filtres à une fréquence supérieure d'un Bark et/ou inférieure d'un Bark à sa fréquence centrale est d'au moins 40 dB.

10. Déterminateur de seuil de masquage (100, 200, 340, 1200, 1300, 3200) selon l'une quelconque des revendications précédentes,
dans lequel le déterminateur de seuil de masquage est configuré pour effectuer un traitement supplémentaire, par exemple pour prendre en compte le post-masquage, dans un domaine non linéaire.

11. Déterminateur de seuil de masquage (100, 200, 340, 1200, 1300, 3200) selon la revendication 10,

dans lequel le déterminateur de seuil de masquage est configuré pour appliquer un mappage non linéaire (1352, 3222) aux grandeurs respectives des valeurs complexes du signal passe-bande tout en conservant inchangées les valeurs de phase respectives des valeurs complexes, à l'exception d'une correction de phase facultative (231, 3231) ; et
dans lequel le déterminateur de seuil de masquage est configuré pour effectuer un traitement supplémentaire des amplitudes mappées de manière non linéaire du signal passe-bande afin de prendre en compte le post-masquage.

12. Codeur audio pour coder un signal audio d'entrée,

comprenant le déterminateur de seuil de masquage (100, 200, 340, 1200, 1300, 3200) selon l'une quelconque des revendications précédentes,
dans lequel le codeur audio est configuré pour ajuster un pas de quantification pour quantifier le signal audio d'entrée, ou une version prétraitée de celui-ci, en fonction du seuil de masquage.

13. Codeur audio selon la revendication 12, configuré pour

déterminer pour la région de fréquence donnée une valeur plus grande des informations de seuil de masquage obtenues (121, 221, 321, 341, 1221, 1244, 1321, 1341, 1520-1550, 1820-1850, 1920-1950, 2020, 3221, 3321) et un seuil prédéterminé dans le silence (324, 3250), et
sélectionner une taille de pas de quantification pour la région de fréquence donnée en fonction de la valeur déterminée la plus grande, et, éventuellement,
encoder un signal audio en utilisant la taille de pas de quantification sélectionnée.

14. Procédé pour déterminer des informations de seuil de masquage (121, 221, 321, 341, 1221, 1244, 1321, 1341, 1520-1550, 1820-1850, 1920-1950, 2020, 3221, 3321), comprenant le fait de

obtenir une pluralité de signaux passe-bande (111, 211, 311, 1211, 1311, 3211) en utilisant une pluralité de filtres (110, 210, 310, 1210, 1310, 3210) ayant différentes largeurs de bande, et
obtenir les informations de seuil de masquage associées à une région de fréquence donnée sur la base des valeurs de signal passe-bande d'au moins deux signaux passe-bande (111, 211, 311, 1211, 1311, 3211) ;
dans lequel les valeurs de signal passe-bande sont des valeurs complexes ;
dans lequel le procédé comprend le fait de prendre en compte des phases des valeurs de signal passe-bande lors de l'obtention des informations de seuil de masquage (121, 221, 321, 341, 1221, 1244, 1321, 1341, 1520-1550, 1820-1850, 1920-1950, 2020, 3221, 3321) associées à la région de fréquence donnée sur la base des valeurs de signal passe-bande de l'au moins deux signaux passe-bande (111, 211, 311, 1211, 1311, 3211) ;

dans lequel le procédé comprend le fait d'appliquer une valeur de correction de phase (231, 3231) à au moins l'un des au moins deux signaux passe-bande (111, 211, 311, 1211, 1311, 3211) lors de l'obtention des informations de seuil de masquage (121, 221, 321, 341, 1221, 1244, 1321, 1341, 1520-1550, 1820-1850, 1920-1950, 2020, 3221, 3321).

15. Programme informatique permettant d'exécuter le procédé selon la revendication 14, lorsque le programme informatique est exécuté sur un ordinateur.

EP 4 552 121 B1

Fig. 1

Fig. 2

Fig. 3

404
semicircular
canals

403
stirrup (adjacent on
the oval window)

405
nerv of the
vestibular organ

401
malleus

402
incus

411
ear drum

406
auditory
nerve

407
cochlea

413
auricle

412
outer ear
canal

410
tympanic
cavity

409
round
window

408
eustachian
tube

Fig. 4

cochlea

506

| 505 | 0 | 8 | 16 | 24 | 32mm | length |
| 504 | 0 | 160 | 320 | 480 | 640 | number of steps |
| 503 | 0 | 600 | 1200 | 1800 | 2400mel | ratio pitch |

502　　0　　3　　6　　9　　12　　15　　18　　21　　24Bark　critical-band rate

501　　0　0.125　0.25　0.5　1　2　4　8　16kHz　frequency

Fig. 5

EP 4 552 121 B1

Fig. 6

EP 4 552 121 B1

Fig. 7

Fig. 8

Fig. 9

EP 4 552 121 B1

Fig. 10

Fig. 11

Fig. 12a

Fig. 12b

**Algorithm 1** perceptual model

```
 1:  procedure LINEAR COMPLEX SPREADING
 2:      z_corr ← band specific phase correction factors
 3:      in ← APGF filterbank output values
 4:      out ← in
 5:      for i ∈ {1, . . . , numBands} do
 6:          du ← in(i)
 7:          dd ← du
 8:          for j ∈ {i + 1, . . . , numBands} do
 9:              du ← du∗z_corr,u(j)∗u
10:              out(j) ← out(j)+du
11:          for j ∈ {i - 1, . . . ,1} do
12:              dd ← dd∗z_corr,l(j)∗l
13:              out(j) ← out(j)+dd
14:      return out
```

## Fig. 13

Fig. 14

EP 4 552 121 B1

impulse response magnitudes

5 ⋯⋯⋯⋯ ∿1510
5 complex linear ----------- ∿1520
5 complex nonlinear - - - - ∿1530
5 magnitude linear —— —— ∿1540
5 magnitude nonlinear —— —— · ∿1550

Fig. 15

EP 4 552 121 B1

Fig. 16

Fig. 17

EP 4 552 121 B1

average

Fig. 18

average

Fig. 19

Fig. 20

Fig. 21

Fig. 22

Fig. 23

Fig. 24

Fig. 25

EP 4 552 121 B1

Fig. 26

Fig. 27

Fig. 28

Fig. 29

Fig. 30

Fig. 31

Fig. 32

Algorithm 1 perceptual model

```
 1:  procedure LINEAR COMPLEX SPREADING
 2:      z_corr ← band specific phase correction factors
 3:      in ← APGF filterbank output values
 4:      out ← in
 5:      for i ∈ {1, . . . , numBands} do
 6:          du ← in(i)
 7:          dd ← du
 8:          for j ∈ {i+1, . . . , numBands} do
 9:              du ← du*z_corr,u(j)*u
10:              out(j) ← out(j) + du
11:          for j ∈ {i-1, . . . ,1} do
12:              dd ← dd*z_corr,u(j)*l
13:              out(j) ← out(j) + dd
14:      return out
```

EP 4 552 121 B1

Fig. 33

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021113416 A1
- WO 20210610 A1
- WO 9962189 A2
- WO 19991202 A2

**Non-patent literature cited in the description**

- **LARS CHITTKA ; AXEL BROCKMANN ; PERCEPTION SPACE-THE FINAL FRONTIER**. *PLoS biology*, 2005, vol. 3 (4), e137
- **HUGO FASTL ; EBERHARD ZWICKER**. Psychoacoustics: facts and models. Springer Science & Business Media, 2006, vol. 22
- **BRIAN CJ MOORE**. An introduction to the psychology of hearing. *Brill*, 2012
- **RICHARD F LYON**. The all-pole gammatone filter and auditory models. *Acustica. Citeseer*, 1996
- History and future of auditory filter models. **RICHARD F LYON ; ANDREAS G KATSIAMIS ; EMMANUEL M DRAKAKIS**. Proceedings of 2010 IEEE International Symposium on Circuits and Systems. IEEE, 2010, 3809-3812
- **FRANK BAUMGARTE ; CHARALAMPOS FEREKIDIS ; HENDRIK FUCHS**. *A nonlinear psychoacoustic model applied to the iso mpeg layer 3 coder, 99th aes convention*, October 1995
- ITUR Recommendation. Methods for objective measurements of perceived audio quality. *ITU-R BS*, 2001, 13871